# EUROPÄISCHE PATENTSCHRIFT

(11) **EP 2 928 634 B1**
(45) Veröffentlichungstag und Bekanntmachung des Hinweises auf die Patenterteilung: **21.02.2018**
(21) Anmeldenummer: 13815698.9
(22) Anmeldetag: 05.12.2013
(51) Int. Cl.: B23K 1/00, B23K 1/08, B23K 3/06, H05K 3/34

(54) **VERFAHREN UND LÖTVORRICHTUNG ZUM SELEKTIVLÖTEN MIT MINDESTENS EINER LÖTDÜSE UND EINEM ANDEREN FUNKTIONSELEMENT, DIE DURCH EINE BEWEGUNGSEINRICHTUNG SYNCHRON BEWEGT WERDEN**
METHOD AND SOLDERING DEVICE FOR SELECTIVE SOLDERING WITH AT LEAST ONE SOLDER NOZZLE AND ANOTHER FUNCTIONAL ELEMENT WHICH ARE MOVED SYNCHRONOUSLY BY A MOVEMENT DEVICE
PROCÉDÉ ET DISPOSITIF DE BRASAGE PERMETTANT UN BRASAGE SÉLECTIF COMPORTANT AU MOINS UNE BUSE DE BRASAGE ET UN AUTRE ÉLÉMENT FONCTIONNEL DÉPLACÉS DE FAÇON SYNCHRONE AU MOYEN D'UN ÉLÉMENT DE DÉPLACEMENT

(30) Priorität: 07.12.2012 DE 102012111946; 08.11.2013 DE 102013112320
(43) Veröffentlichungstag der Anmeldung: 14.10.2015
(73) Patentinhaber: SEHO Systemtechnik GmbH, 97892 Kreuzwertheim (DE)
(72) Erfinder: DREIKORN, Bernd, 97877 Wertheim (DE); HERZ, Thomas, 97892 Kreuzwertheim (DE); ZOCH, Reiner, 01454 Radeberg (DE); WALTER, Markus, 97877 Wertheim (DE)
(74) Vertreter: Patronus IP Patent- und Rechtsanwälte
(86) Internationale Anmeldenummer: PCT/EP2013/075733
(87) Internationale Veröffentlichungsnummer: WO 2014/086954

(56) Entgegenhaltungen:
- DE-A1-102004 063 488
- JP-A- 2004 358 501
- JP-A- 2006 055 904
- JP-A- 2006 136 925
- JP-A- 2008 109 033
- JP-A- 2010 021 356
- JP-A- 2012 146 842

## Beschreibung

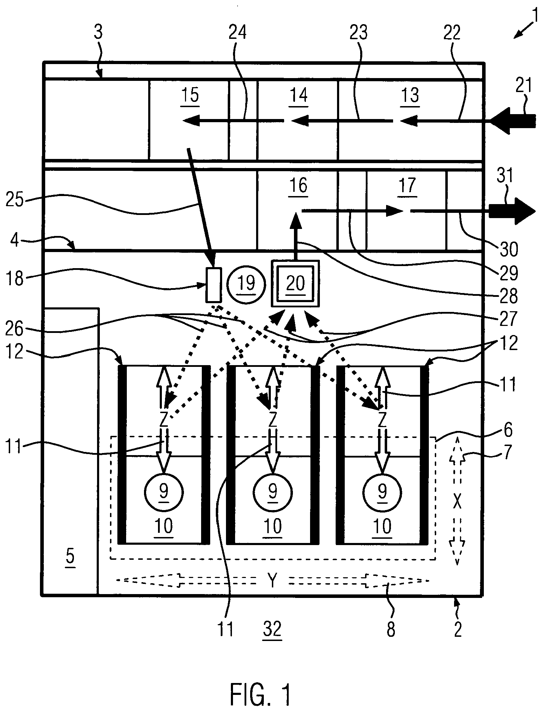

Die vorliegende Erfindung betrifft ein Verfahren und eine Lötvorrichtung zum Selektivlöten nach dem Oberbegriff der Ansprüche 1 und 4 (siehe, z.B. JP 2012 146842 A). In der DE 10 2004 063488A1 ist eine Anlage zum automatischen Erkennen und Beheben von Lötfehlern an mit elektronischen Bauteilen bestückten Leiterplatten offenbart. Die Anlage umfasst eine Transporteinrichtung, die als Schienenförderer ausgebildet ist und zwei Transport- oder Führungsschienen aufweist. Eine Leiterplatte wird mit Ihren parallel zur Transportrichtung verlaufenden Seitenkanten in den Transport- oder Führungsschienen geführt. Auf einem gemeinsamen Träger sind eine Kamera und zwei Wellenlöteinrichtungen und angeordnet. Der Träger weist eine Brücke bestehend aus zwei Längsträgern und zwei Querträgern auf, wobei die Brücke in X-Richtung, d.h. in Transportrichtung der Leiterplatte, auf Führungsbahnen verfahrbar ist. An den Querträgern ist eine zweite Brücke in y-Richtung verfahrbar angeordnet. Somit lassen sich Kamera und Wellenlöteinrichtung in X- und Y-Richtung frei positionieren.
Aus der JP 2012 146842 A gehen ein Verfahren und eine Vorrichtung zum Selektivlöten hervor. Diese Vorrichtung umfasst Mittel, um die relative Position des geschmolzenen Lotes auf einer Düse und des zu verlötenden Werkstücks relativ zueinander derart anzuordnen, dass diese nicht kontaktieren. Dann wird ein vorbestimmter Bereich des Werkstücks mittels einer Heizeinrichtung aufgeheizt. Anschließend kontaktieren das geschmolzene Lot der Düse und der vorbestimmte Bereich des Werkstücks die miteinander verlötet werden sollen, wodurch es möglich sein soll lediglich den zu verlötenden Bereich zu verlöten (Zusammenfassung Figuren 1, 4 und 5).
Aus der JP 2006 055904 A geht ein Behälter zum Vorhalten von Lot hervor. Ein Körper dieses Behälters weist einen oberen und zwei untere Kammern mit einer horizontalen Membran auf. Der untere Bereich ist in eine Primär- und eine Sekundärkammer mittels einer vertikalen Membran aufgeteilt.

Aus der JP 2010 021356 A geht eine Lotvorrichtung hervor. Diese Vorrichtung umfasst Bewegungseinrichtungen, um eine bedruckte Leiterplatte in vertikaler Richtung anzuheben, so dass diese von einer Aufnahmeeinrichtung in eine Greifposition und in eine Lötposition überführbar ist.

Aus der JP 2008 109033 A geht eine Lötvorrichtung und ein System zur Herstellung einer bedruckten Leiterplatte mit dieser Vorrichtung hervor. Diese Vorrichtung umfasst ein Mittel zum Befestigen einer Lötdüse, mit dem eine Lötdüse die in der Breite verstellbar ist, entsprechend der zu verlötenden Lötstelle positionierbar ist Weiterhin können mehrere Lötdüsenbefestigungsmittel mit entsprechenden Lötdüsen vorgesehen sein, um mehrere Lötstellen gleichzeitig zu verlöten.

Eine Lötvorrichtung zum Selektivlöten mit einem Lötbad zum Vorhalten von geschmolzenem Lot, zumindest einer Lötdüse, einer Lotpumpe zum Fördern von Lot aus dem Lötbad durch die Lötdüse und einer Bewegungseinrichtung zum relativen Bewegen der Lötdüse und einer zu lötende Baugruppe ist beispielsweise aus der DE 10 2007 002 777 A1 bekannt. Hierbei wird eine zu lötende Baugruppe (Leiterplatte) in einen Lötbereich transportiert und beispielsweise auf einer Haube abgelegt und sodann die Haube zusammen mit der Baugruppe über eine Anordnung einer Mehrzahl unterschiedlicher, an sich feststehender Düsen abgesenkt. Weitere Einzelheiten einer Selektivlötvorrichtung, die für ein manuelles Bewegen einer zu lötenden Baugruppe eingerichtet ist, sind beispielsweise in der DE 43 14 241 C2 beschrieben.

In den letzten Jahren hat sich das Selektivlöten mittels einer Miniaturwelle zunehmend verbreitet. Dabei wird die zu lötende Baugruppe mittels einer Positioniereinrichtung und eines Werkstückträgers oder mittels Direktboardhandling nach Benetzung mit Flussmittel und Vorheizung über eine sehr kleine Lötdüse gebracht, in XY-Richtung punktgenau positioniert und zur Lötung auf die Düse abgesenkt. Beim Direktboardhandling liegt die zu lötende Baugruppe unmittelbar auf der Transporteinrichtung auf. Einem Lötprogramm folgend wird jeder zu lötende Punkt angefahren und gelötet. Weitere Einzelheiten sind beispielsweise dem Artikel "Wellenlöten", insbesondere Abschnitt "Variationen", Unterabschnitt "Selektivlöten" auf der Internet-Seite http://de.wikipedia.org/wiki/Wellenlöten#Selektivlöten zu entnehmen.

Unter dem Handelsnamen Ersa VERSAFLOW 3/45 wird von der der Firma kurtz ersa eine In-Line Selektivlötvorrichtung angeboten. Hierbei können entlang einer geradlinigen Fördersterecke mehrere Löststationen angeordnet sein. Es können mehrere Baugruppen gleichzeitig gelötet werden.
Eine Aufgabe der vorliegenden Erfindung besteht darin, ein Verfahren zum Selektivlöten und eine Lötvorrichtung zum Selektivlöten bereitzustellen, mit welchen die Nachteile im Stand der Technik vermieden oder abgemildert werden können. Insbesondere bestehen Teilaufgaben der vorliegenden Erfindung darin, ein Verfahren und eine Lötvorrichtung zum Selektivlöten bereitzustellen, mit welchen mit hohem Durchsatz und geringem gerätetechnischen und steuerungstechnischen Aufwand sehr flexibel unterschiedliche Baugruppen gelötet werden können. Ein Verfahren und eine Vorrichtung zum Selektivlöten gemäß der Erfindung sind in den Ansprüchen 1 und 4 definiert. Vorteilhafte Ausführungsformen und Weiterbildungen der Erfindung sind in den jeweiligen Unteransprüchen 2-3 und 5-13 angegeben. Dieser Erfindung liegt die Erkenntnis zugrunde, dass ein Lötprogramm zyklisch ist und dass zu einem beliebigen Zeitpunkt begonnen werden kann, denn grundsätzlich ist es nicht entscheidend, welche Lötstellen zu Beginn bzw. am Ende des Lötprogrammes gelötet bzw. bearbeitet werden. Die einzelnen Baugruppen müssen nicht gleichzeitig, sondern können auch nacheinander (asynchron) in die Lötvorrichtung bzw. in die entsprechenden Arbeitsstationen eingebracht werden. Dadurch können die einzelnen Baugruppen einerseits aufeinander folgend der Vorbearbeitung (Auftragen von Flussmittel, Aufheizen, Lagekorrektur, Z-Korrektur) und der Nachbearbeitung (AOI, Kühlung) unterzogen werden und dennoch können mehrere Baugruppen parallel gelötet werden, und andererseits ist es möglich, dass eine oder mehrere Baugruppen parallel gelötet werden und eine oder mehrere weitere Baugruppen hierzu parallel bearbeitet werden, wobei die Bearbeitung u.a. ein Besprühen mit Flußmittel, ein Vorheizen und/oder eine optische Inspektion umfassen können.

Ein asynchrones Beschicken der einzelnen Lötdüsenanordnungen erlaubt die Verwendung einer einzelnen Beschickungseinrichtung zum Versorgen mehrerer Lötdüsenanordnungen. Dies erlaubt eine hohe Flexibilität, bewirkt einen hohen Durchsatz und mit einer gemeinsamen Steuereinrichtung kann das Lötprogramm in mehreren Lötdüsenanordnungen ausgeführt werden. Beim asynchronen Beschicken werden die Baugruppen zeitlich versetzte in die Lötdüsenanordnungen eingekoppelt, womit sie zu unterschiedlichen Bearbeitungsfortschritten in ein zyklische Lötprogramm eingekoppelt werden. Hierdurch können gleichzeitig mehrere Baugruppen gelötet werden, jedoch die Vor- und Nachbehandlung der einzelnen Baugruppen erfolgt einzeln.

Beim Einkoppeln einer Baugruppe wird vorzugsweise die Bewegung in der X-Y-Ebene angehalten, wobei der Fluß an Lötmittel normalerweise nicht angehalten wird.

Gemäß einer Weiterbildung der vorliegende Erfindung werden die Baugruppen jeweils durch eine relative Vertikalbewegung zu den Lötdüsenanordnungen in das Lötprogramm ein- bzw. ausgekoppelt, wobei nicht zu allen Lötanordnungen gleichzeitig jeweils eine Baugruppe eingekoppelt wird, so dass zumindest zwei Baugruppen zu einem unterschiedlichen Zeitpunkt (asynchron) in das Lötprogramm eingekoppelt worden sind.

Gemäß einer Weiterbildung der vorliegenden Erfindung, wird in einer Lötdüsenanordnung lediglich ein Teilabschnitt eines auszuführenden Lötprogrammes für eine Baugruppe ausgeführt, und alle Teilabschnitte, die mit einer Baugruppe an den unterschiedlichen Lötdüsenanordnungen ausgeführt werden stellen zusammen ein vollständiges Lötprogramm für diese Baugruppe dar.

Nach einer vorteilhaften Weiterbildung wird beim Einkoppeln einer Baugruppe in eine Lötdüsenanordnung die relative Bewegung zwischen der Baugruppe und einer der Lötdüsen in der X-Y-Ebene angehalten.
Beim Einkoppeln einer Baugruppe in eine Lötdüsenanordnung kann der Fluss des Lotes durch die Lötdüsen angehalten werden.

Vorzugsweise ist eine Steuereinrichtung vorgesehen, die derart ausgebildet ist, dass mehrere zu lötende Baugruppen synchron gelötet werden, indem mit einer Bewegungseinrichtung zumindest zwei Lötdüsenanordnungen oder zumindest eine Lötdüsenanordnung und ein weiteres Funktionselement in der X-Y-Ebene synchron relativ zu jeweils einer der Baugruppen bewegt werden.
Nach einer Weiterbildung der Erfindung ist sind mehrere Lötdüsen in mehreren Lötdüsenanordnungen vorgesehen, wobei jede Lötdüsenanordnung eine oder mehrere Lötdüsen aufweist, wobei einer jeden Lötdüsenanordnung ein Lötbereich zugeordnet ist, und die Beschickungseinrichtung ist zum Zuführen von Baugruppen in die mehreren Lötbereiche derart ausgebildet, dass die Förderwege der einzelnen Baugruppen derart verzweigen, dass ein jeder Lötbereich unabhängig von den jeweiligen anderen Lötbereichen mit einer Baugruppe beschickt werden kann oder von ihm abgezogen werden kann.
Die Bewegungseinrichtung kann so ausgebildet sein, dass die Lötdüsen in den einzelnen Lötbereichen unabhängig voneinander bewegt werden können, so dass in den einzelnen Lötbereichen unterschiedliche Lötprogramme ausführbar sind. Es ist selbstverständlich auch möglich, dass in den einzelnen Lötbereichen die gleichen Lötprogramme ausgeführt werden und insbesondere diese synchron ausgeführt werden.
Der Förderweg der Baugruppen verzweigt bspw. innerhalb einer horizontalen Ebene, so dass von einem Linearförderer an mehreren Stellen seitlich die Baugruppen abgezweigt werden können und jeweils einem Lötbereich zugeführt werden können.
Der Förderweg kann auch in Vertikalrichtung verzweigen. Z.B. können die mehreren Lötbereiche geradlinig aufeinanderfolgend angeordnet sein, wobei die Beschickungseinrichtung eine Hubeinrichtung aufweist, mit welcher die Baugruppen angehoben und oberhalb der Lötbereiche über diese hinweg bewegt werden können.
Aufgrund der Verzweigung des Förderweges ist es möglich, dass einzelne z.B. kleine Baugruppen, die innerhalb kurzer Zeit vollständig gelötet werden, andere z.B. große Baugruppen, deren Lötung wesentlich länger dauert, innerhalb der Lötvorrichtung überholen. Hierdurch können in den einzelnen Lötbereichen unterschiedliche Baugruppen mit unterschiedlichen Lötprogrammen ausgeführt werden, ohne dass eine Baugruppe auf das Beenden des Lötprogrammes der anderen Baugruppe warten muss. Einrichtungen zur Vor- oder Nachbearbeitung der Baugruppen, wie z.B. Heizeinrichtung, Flussmittelbenetzungseinrichtung, Prüfeinrichtung, etc. müssen lediglich einfach vorgesehen sein und können von allen Baugruppen benutzt werden.
Ein sich verzweigender Förderweg kann unabhängig von der Bewegungseinrichtung zum synchronen relativen Bewegen einer Lötdüse und einem weiteren Funktionselement bzgl. jeweils einer Baugruppe in einer Lötanlage eingesetzt werden und stellt deshalb einen selbständigen, unabhängigen Erfindungsgedanken dar.
Die Lötvorrichtung ist vorzugsweise derart ausgebildet, dass die einzelnen Lötdüsenanordnungen und die jeweiligen Baugruppen unabhängig voneinander in Vertikalrichtung (Z-Richtung) mittels einer Koppeleinrichtung zueinander bewegbar sind. Mehrere Lötdüsen sind in mehreren Lötdüsenanordnungen vorgesehen, wobei jede Lötdüsenanordnung eine oder mehrere Lötdüsen aufweist, wobei einer jeden Lötdüsenanordnung eine Baugruppe zuordbar ist, und die Bewegungseinrichtung zum synchronen Bewegen der mehreren Lötdüsenanordnungen bezüglich der jeweiligen Baugruppen in der horizontalen X-Y-Ebene ausgebildet ist, und eine Koppeleinrichtung vorgesehen ist, mit der die einzelnen Lötdüsenanordnungen und die jeweiligen Baugruppen unabhängig voneinander in Vertikalrichtung (Z-Richtung) zueinander bewegbar sind, so dass die Baugruppen individuell in das Lötprogramm einkoppelbar sind.

Diese Koppeleinrichtung kann ein Z-Antrieb zum individuellen Bewegen der Lötdüsenanordnungen oder zum individuellen Bewegen von Positionierrahmen sein, wobei jeweils ein Positionierrahmen eine Baugruppe aufnehmen kann. Die Koppeleinrichtung kann auch eine Greifeinrichtung, insbesondere ein Greifroboter sein, mit dem jeweils eine Baugruppe in einen in Vertikalrichtung (Z-Richtung) nicht beweglichen Positionierrahmen einsetzen kann, wobei die Düsenanordnungen hier auch nicht in Vertikalrichtung beweglich ausgebildet sein müssen. Die individuelle Zuführung bzw. Einkopplung in ein Lötprogramm erfolgt durch die von der Greifeinrichtung durchgeführte Vertikalbewegung der Baugruppe bzgl. der jeweiligen Lötdüsenanordnung.

Da die mehreren Lötdüsenanordnungen synchron bezüglich der jeweiligen Baugruppen in der horizontalen X-Y-Ebene bewegt werden, führen alle Düsen in X- und Y-Richtung das gleiche Lötprogramm aus. Da die einzelnen Lötdüsenanordnungen und die jeweiligen Baugruppen unabhängig voneinander in Vertikalrichtung (Z- Richtung) zueinander bewegbar sind, kann eine neu zu lötende Baugruppe zu einem beliebigen Zeitpunkt bzw. zu einem beliebigen Arbeitsfortschritt des Lötprogramms in den Lötbereich eingesetzt werden. Bei einer Ausführungsform der Erfindung wird durch Anheben der Lötdüse bzw. der Lötdüsenanordnung in Z-Richtung die jeweilige Baugruppe in das laufende Programm eingekoppelt. Während des Einkoppelns kann das Lötprogramm in X- und Y-Richtung kurz angehalten werden. Danach werden die Lötdüsenanordnungen weiter synchron miteinander bewegt. Mit einer vergleichsweise kleinen Anlage kann somit ein hoher Durchsatz erzielt werden. Zudem sind Vor- und Nachbehandlungseinrichtungen, wie z.B. eine Vorheizung, eine Kühlung, eine Z-Korrektur, eine Lagekorrektur, ein Teach-Modul und eine AOI nur einfach notwendig. Ein wesentlicher Vorteil der Erfindung liegt auch darin, dass nur eine Bewegungsvorrichtung zum Bewegen der Lötdüsen in der X-Y-Ebene und nur eine Koppeleinrichtung zum Einsetzen der Baugruppen vorgesehen werden muss.

In einer bevorzugten Ausgestaltung sind eine oder mehrere X-Y-Bewegungseinheiten definiert, wobei jede X-Y-Bewegungseinheit eine oder mehrere, vorzugsweise jeweils eine gleiche Anzahl von Lötdüsenanordnungen aufnimmt, wobei die Bewegungseinrichtung derart ausgebildet ist, dass mehrere Gruppen von X-Y-Bewegungseinheiten unabhängig voneinander in der X-Y-Ebene bewegbar sind. Somit kann die Relativbewegung in der X-Y-Ebene durch Bewegung der Düsen in einer oder mehreren Gruppen verwirklicht werden. Daher können die Baugruppen selbst stillstehen, und mechanische Nachwirkungen einer Bewegung der Baugruppen können eine Positionsgenauigkeit nicht beeinträchtigen. Alternativ oder zusätzlich können auch mehrere Baugruppen gemeinsam synchron in der X-Y-Ebene bewegbar sein.

Grundsätzlich ist es möglich, dass die Lötdüsenanordnungen einer X-Y-Bewegungseinheit ein gemeinsames Lötbad aufweisen. Wenn jeder Lötdüsenanordnung ein Lötbad mit wenigstens einer Lotpumpe zugeordnet ist und jedes Lötbad zusammen mit der jeweiligen Lötdüsenanordnung bewegbar ist, können Schwapp-Bewegungen des Lötbades aufgrund der X-Y-Bewegung reduziert werden.

In einer weiteren bevorzugten Ausgestaltung ist die Bewegungseinrichtung derart ausgebildet, dass jede Lötdüsenanordnung insgesamt oder einzelne oder Gruppen der Lötdüsen jeder Lötdüsenanordnung unabhängig von anderen Lötdüsen der selben Lötdüsenanordnung in Vertikalrichtung bewegbar ist bzw. sind. Auf diese Weise können die Baugruppen auch in Z-Richtung feststehend bleiben und kann die Positionsgenauigkeit durch ein anderenfalls häufiges Anheben und Absenken nicht beeinträchtigt werden. Alternativ oder zusätzlich dazu können trotzdem die einzelnen Baugruppen unabhängig voneinander in Z-Richtung bewegbar sein.

Es können Lötdüsen unterschiedlicher Art vorgesehen sein, wobei die Arten von Lötdüsen sich in Form und/oder Durchmesser einer Lotaustrittsöffnung und/oder in einer Belotung oder Nichtbelotung einer Düsenwandung unterscheiden, wobei vorzugsweise Lötdüsen einer einzigen Art in einer Lötdüsenanordnung zusammengefasst sind.

Wenn die Bewegungseinrichtung derart ausgebildet ist, dass einzelne oder alle Lötdüsen um eine Lötdüsen-Längsachse drehbar sind, können Lötdüsen mit Vorzugsrichtung in beiden Richtungen der X-Y-Ebene vorteilhaft eingesetzt werden. Alternativ oder zusätzlich dazu können die Baugruppen selbst drehbar sein. Der Drehbereich für die Lötdüsen bzw. für die Baugruppen beträgt vorzugsweise 0° bis 180° bzw. 0° bis 90°.

Vorzugsweise sind mehrere Baugruppenhalteeinrichtungen, wie z.B. Positionierrahmen, zum Aufnehmen jeweils einer Baugruppe vorgesehen und weist die Bewegungseinrichtung eine Beschickungseinrichtung zum Einsetzen der Baugruppen in die jeweiligen Baugruppenaufnahmeeinrichtungen und zum Entnehmen der Baugruppen aus den jeweiligen Baugruppenaufnahmeeinrichtungen auf. Die Vorteile der Erfindung können besonders wirksam zum Tragen kommen, wenn die Beschickungseinrichtung einen einzigen Greifer zum Einsetzen und Entnehmen von Baugruppen aufweist.

In einer weiteren bevorzugten Ausgestaltung ist die Lötvorrichtung derart ausgebildet, dass die Baugruppen gegenüber der X-Y-Ebene kippbar sind, wobei ein Kippwinkel zwischen 5 und 15°, vorzugsweise zwischen 7 und 12° festlegbar ist. Ein Neigungswinkel kann bei Einsatz bestimmter Lötdüsen mit Vorzugsrichtung vorteilhaft sein. Der Neigungswinkel kann fest vorgegeben oder veränderbar sein, ggf. über das Lötprogramm eingestellt werden.

Das Lötprogramm kann durch eine Steuereinrichtung durchgeführt werden.

Die Erfindung nach einem weiteren Aspekt zeichnet sich dadurch aus, dass mehrere Lötdüsen in mehreren Lötdüsenanordnungen vorgesehen sind, und jede Lötdüsenanordnung eine oder mehrere Lötdüsen aufweist, wobei einer jeden Lötdüsenanordnung ein Lötbereich zuordbar ist, und eine Transporteinrichtung vorgesehen ist, die zu lötende Baugruppen sequentiell zu den Lötdüsenanordnungen befördert, wobei eine Steuereinrichtung die Bewegungseinrichtung zur relativen Bewegung der Lötdüsen bzgl. der Baugruppe derart ansteuert, dass in einer Lötdüsenanordnung lediglich ein Teilabschnitt eines auszuführenden Lötprogrammes für eine Baugruppe ausgeführt wird, wobei die Steuereinrichtung alle Teilabschnitte eines Lötprogramms, derart mit einer Baugruppe an den unterschiedlichen Lötdüsenanordnungen ausführt, dass die Teilabschnitte zusammen ein vollständiges Lötprogramm für diese Baugruppe darstellen.

Die Transporteinrichtung zum Führen von Baugruppen ist vorzugsweise linear ausgebildet.

Die Vorrichtung gemäß diesem Aspekt kann auch als Doppel- oder Mehrspur-Vorrichtung ausgebildet sein.

Vorteilhaft ist gemäß dem Verfahren nach diesem weiteren Aspekt, dass in einer Lötdüsenanordnung lediglich ein Teilabschnitt des auszuführenden Lötprogrammes für eine Baugruppe ausgeführt wird. Das bedeutet, wenn eine in der Transportrichtung weiter vorne angeordnete erste Baugruppe zu Ende gelötet ist, dann ist es möglich das Lötprogramm einer dahinter angeordneten zweiten Baugruppe zu unterbrechen so dass nur ein Teilabschnitt des betreffenden Lötprogramms ausgeführt wird. Die erste Baugruppe kann dann entnommen werden. Anschließend wird die zweite Baugruppe mit der Transporteinrichtung über dem Lötbad, an dem zuvor die erste Baugruppe angeordnet war, transportiert. Das unterbrochene Lötprogramm wird dann entsprechend fortgesetzt, so dass alle Teilabschnitte, die mit einer Baugruppe an den unterschiedlichen Lötdüsenanordnungen ausgeführt werden, zusammen ein vollständiges Lötprogramm dieser Baugruppe darstellen. Auf diese Weise ist es möglich, die hintere Position sofort wieder mit einer zu bearbeitenden Baugruppe zu besetzen. Hierbei können die einzelnen Lötdüsenanordnungen synchron relativ zu den jeweiligen Baugruppen bewegt werden.

Somit ist es möglich ein äußerst effektives Verfahren zum Selektivlöten bzw. eine entsprechende Vorrichtung auszubilden.

Die Erfindung gemäß diesem Aspekt ist mit allen geeigneten Merkmalen der vorher erläuterten Aspekte der vorliegenden Erfindung weiterbildbar.

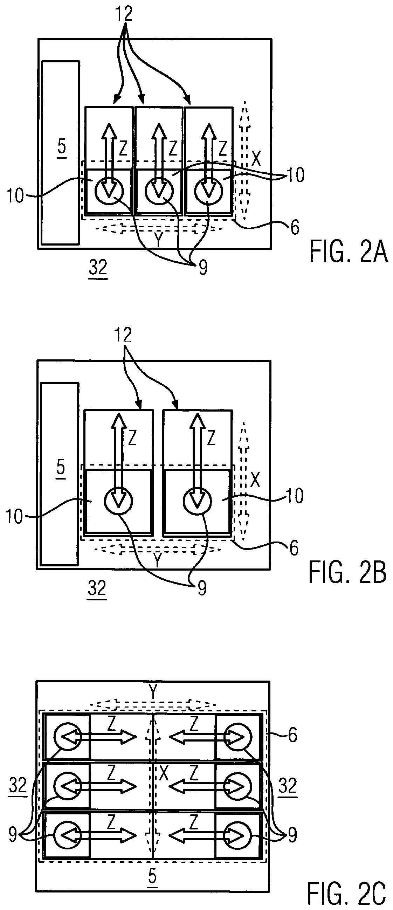

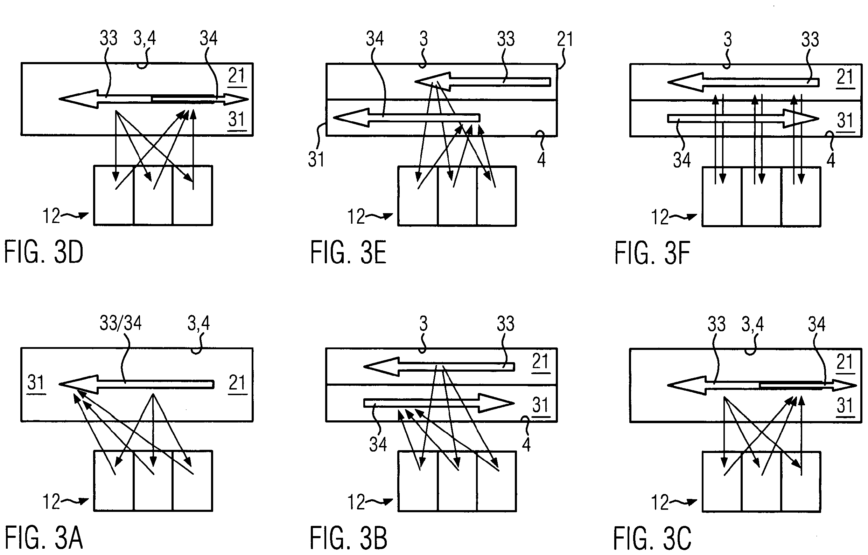

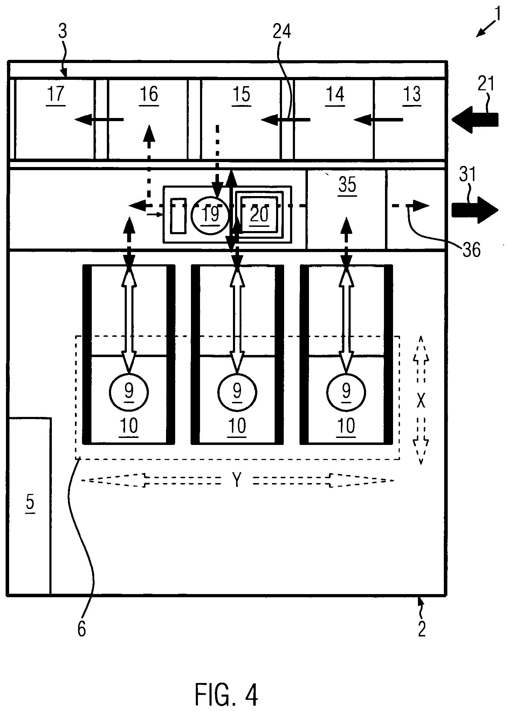

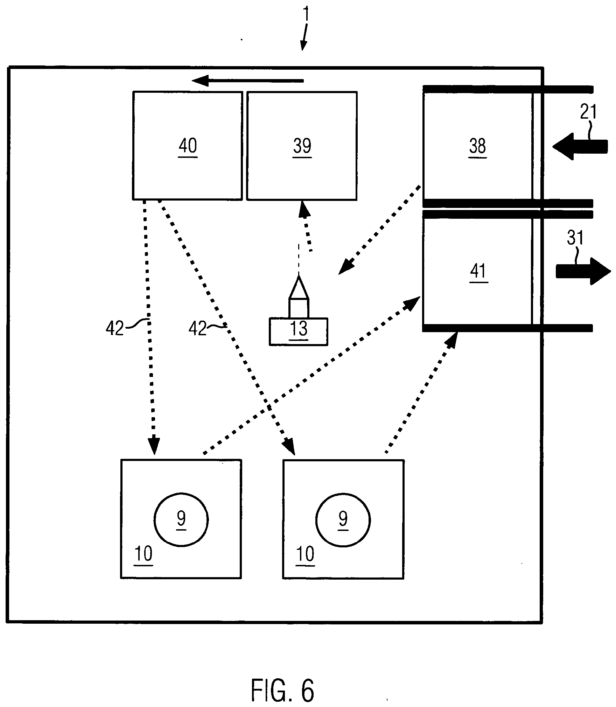

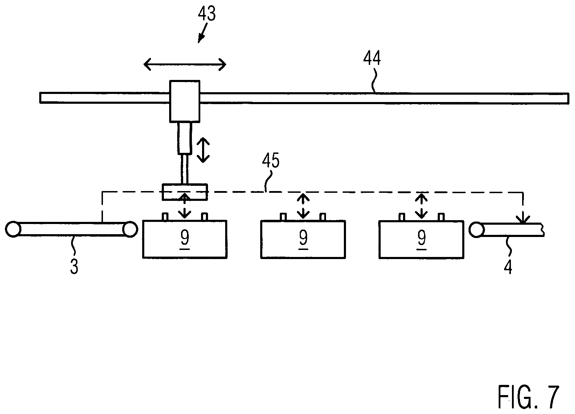

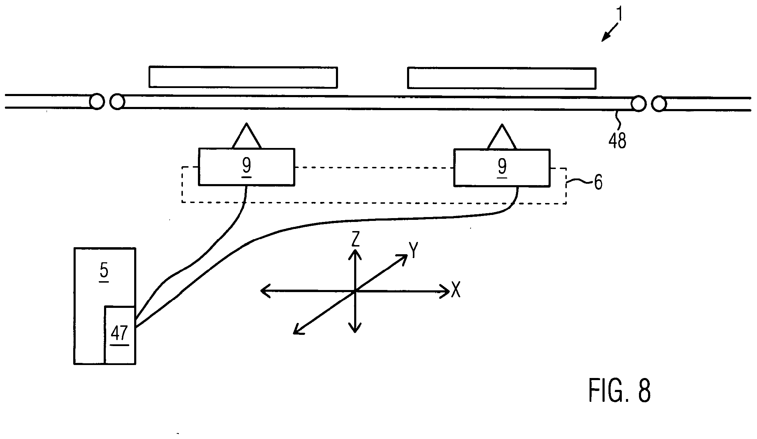

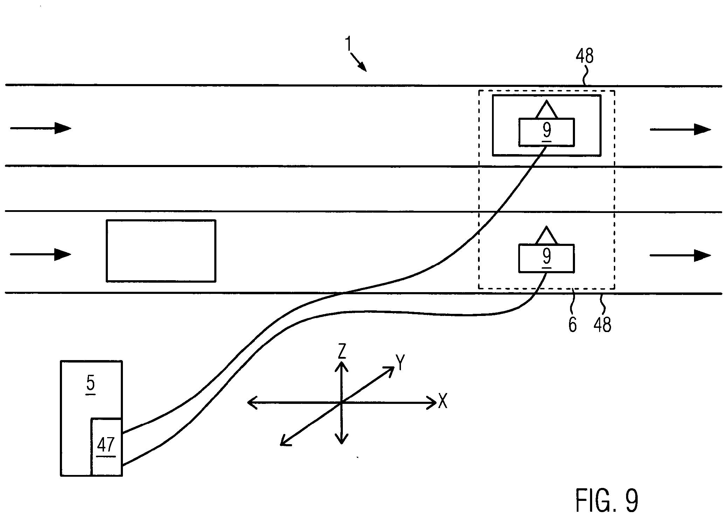

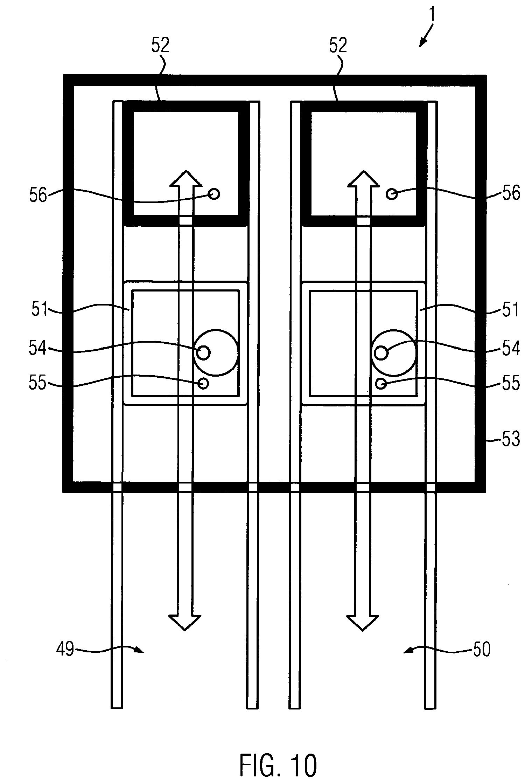

Die Erfindung wird nachstehend anhand des in den Zeichnungen dargestellten Ausführungsbeispiels und einiger Varianten davon erläutert. In den Zeichnungen
- ist Fig. 1: eine grob schematische Darstellung einer Lötanlage nach einem grundlegenden Ausführungsbeispiel der vorliegenden Erfindung;
- sind Fign. 2A bis 2F: schematische Darstellungen von Varianten einer Lotbadanordnung in der Lötanlage von Fig. 1; und
- sind Fign. 3A bis 3F: schematische Darstellungen von Varianten von Transport- und Positionierungseinrichtungen in der Lötanlage von Fig. 1;
- ist Figur 4: eine grob schematische Darstellung einer Lötanlage nach einem weiteren Ausführungsbeispiel der vorliegenden Erfindung;

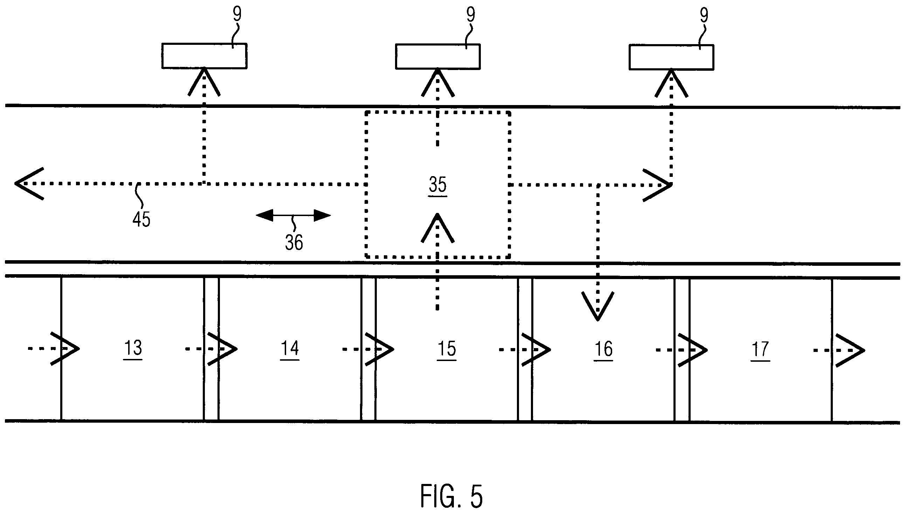

- Figur 5: schematisch ein Shuttlesystem, das bei der Lötanlage gemäß Figur 4 verwendet wird;
- ist Figur 6: eine schematische Darstellung einer Lötanlage nach einem weiteren Ausführungsbeispiel der vorliegenden Erfindung;
- ist Figur 7: eine schematische Darstellung einer Transporteinrichtung für eine Lötanlage;
- ist Figur 8: eine grob schematische Darstellung einer Lötanlage nach einem grundlegenden Ausführungsbeispiel der vorliegenden Erfindung;
- ist Figur 9: eine grob schematische Darstellung einer Lötanlage nach einem weiteren Ausführungsbeispiel der vorliegenden Erfindung, und
- sind Fign. 10-13: grob schematische Darstellungen kompakter Lötanlagen.

Gemäß der Darstellung in Fig. 1 weist eine Lötanlage 1 nach einem grundlegenden Ausführungsbeispiel der vorliegenden Erfindung ein Gestell 2 auf, an welchem ein Einlauf-Förderer 3, eine Auslauf-Förderer 4, ein Schaltschrank 5 und ein Lotbadtisch 6 angeordnet sind. Der Lotbadtisch 6 ist in X-Richtung 7 und in Y-Richtung 8 gegenüber dem Gestell 2 bewegbar. Die X-Richtung 7 und die Y-Richtung 8 definieren eine horizontale Ebene. Auf dem Lotbadtisch 6 sind drei Wellenlötvorrichtungen 9 angeordnet, die jeweils über eine Oberheizung 10 verfügen. Jede der Wellenlötvorrichtungen 9 bzw. eine nicht näher dargestellte Lötdüsenanordnung jeder der Wellenlötvorrichtungen 9 ist einzeln in Z-Richtung 11 bewegbar. Die Z-Richtung 11 ist lotrecht zur X-Y-Ebene und definiert somit die Vertikalrichtung. Zur Bewegung des Lotbadtisches 6 ist ein nicht näher dargestellter XY-Antrieb vorgesehen, der im Folgenden als Bewegungseinrichtung bezeichnet wird. Jeder Wellenlötvorrichtung 9 ist ein Lötbereich zugeordnet, innerhalb dem die Lötdüsen der jeweiligen Lötdüsenanordnung verfahrbar sind. Sowohl die X-Y-Bewegungsrichtungen 7, 8 des Lotbadtisches 6 als auch die Z-Bewegungsrichtungen 11 der einzelnen Lotbäder 9 sind in der Zeichnungsebene dargestellt. Zur Bewegung der einzelnen Lotbäder in Z-Richtung ist ein Z-Antrieb vorgesehen, die im Folgenden als Koppeleinrichtung bezeichnet wird, da er zum Ein- und Auskoppeln einer Baugruppe in ein Lötprogramm dient, wie es unten näher erläutert wird. Es wird darauf hingewiesen, dass die Z-Bewegungsrichtungen 11 der einzelnen Wellenlötvorrichtungen 9 senkrecht zur Zeichnungsebene zu denken sind. Oberhalb des Lotbadtisches 6 sind drei Positionierrahmen 12 angeordnet, die gegenüber dem Gestell 2 feststehend sind.

Im Bereich des Einlauf-Förderers 3 sind eine Flußmittel-Benetzungseinrichtung (Fluxer) 13, eine erste Vorheizeinrichtung 14 und eine zweite Vorheizeinrichtung 15 vorgesehen. Im Bereich des Auslauf-Förderers 4 sind eine erste Kühlstufe 16 und eine zweite Kühlstufe 17 vorgesehen. Ferner sind eine Z-Korrektureinrichtung 18 und eine Anlernvorrichtung 19 in einem Weg zwischen dem Einlauf-Förderer 3 und dem Bereich der Positionierrahmen 12 vorgesehen und ist eine optische Prüfeinrichtung 20 in einem Weg zwischen dem Bereich der Positionierrahmen 12 und dem Auslauf-Förderer 4 vorgesehen. Ferner ist eine Beschickungseinrichtung zum Greifen und Versetzen von Lötgut zwischen dem Einlauf-Förderer 3, den Positionierrahmen 12 und dem Auslauf-Förderer 4 vorgesehen, die jedoch in der Figur nicht näher dargestellt ist. Im vorliegenden Ausführungsbeispiel weist die Beschickungseinrichtung einen Greifer auf, der einzelnen Baugruppen im Raum (X, Y- und Z-Richtung) bzw. Werkstückträger bewegen und an den einzelnen Stationen der Lötanlage aufnehmen und absetzen kann. Auf einem Werkstückträger können auch mehrere Baugruppen angeordnet sein. Mit der Z-Korrektureinrichtung 18 ist es auch möglich eine Durchbiegung einer Baugruppe zu korrigieren, wobei dann die Bewegung der Lötdüsenanordnung in Z-Richtung derart gesteuert wird, dass sie der Kontur der Baugruppe folgt.

Grundsätzlich ist die Lötanlage 1 zur Lötung beliebigen Lötgutes, insbesondere von elektronischen Baugruppen ausgebildet, die Leiterplatten und elektronische Bauelemente umfassen.

Nachstehend wird der Weg und die Behandlung einer Baugruppe (nicht näher dargestellt) in der Lötanlage 1 beschrieben. In der Figur 1 ist der Weg der Baugruppe zu den Lötbereichen in hellen Pfeilen 21 bis 26 dargestellt, während der Weg von den Lötbereichen weg in dunklen Pfeilen 27 bis 31 dargestellt ist. Figur 1 kann man entnehmen, dass der Bewegungsweg der zu lötenden Baugruppen zu den einzelnen Lötbereichen verzweigt (mehrere Pfeile 26), sowie nach den Lötbereichen wieder zusammengeführt wird (mehrere Pfeile 27). Daher können die einzelnen Lötbereiche völlig unabhängig voneinander mit Baugruppen beladen bzw. entladen werden.

Eine zu lötende Baugruppe wird an einer Einlaufstelle 21 dem Einlauf-Förderer 3 übergeben und zu dem Fluxer 13 gefördert (Bewegungsrichtung 22). In dem Fluxer 13 wird die Leiterplatte mit Flussmittel benetzt. Der Fluxer 13 ist in diesem Ausführungsbeispiel ein Sprühfluxer oder Tropfenfluxer, welcher das Flussmittel in X- und Y-Richtung aufsprüht. Der Fluxer 13 weist eine Flussmittelmengenmesseinrichtung (nicht näher dargestellt) und eine Absaugung (nicht näher dargestellt) für Flussmitteldampf auf. Von dem Fluxer 13 aus wird die Leiterplatte weiter zu der ersten Vorheizstufe 14 gefördert (Bewegungsrichtung 23). Die erste Vorheizstufe weist eine Vorheizkassette mit Quarzstrahlern auf, durch welche die Leiterplatte im gesteuerten Modus eine gleichmäßige Temperatur erhält. Die Vorheizstufe kann auch als Konvektionsheizung oder mit einem Infrarot-Strahler ausgebildet sein. Von der ersten Vorheizstufe 14 aus wird die Leiterplatte weiter zu der zweiten Vorheizstufe 15 gefördert (Bewegungsrichtung 24). Die zweite Vorheizstufe 15 ist wie die erste Vorzeitstufe 14 aufgebaut und weist ein Pyrometer zur berührungslosen Temperaturmessung auf, um die Temperatur der Leiterplatte genau einstellen zu können.

Nach Verlassen der zweiten Vorheizeinrichtung 15 wird die Leiterplatte von der nicht näher dargestellten Beschickungseinrichtung ergriffen und zunächst der Z-Korrektureinrichtung 18 zugeführt (Bewegungsrichtung 25). Sodann wird die Leiterplatte in einen der Positionierrahmen 12 gesetzt. Die Z-Korrektureinrichtung 18 dient auch einer Nachjustierung der Lage der Leiterplatte in Z-Richtung in dem Positionierrahmen 12. Bei dem vorliegenden Ausführungsbeispiel sind die Lötbäder bzw. die Düsenanordnungen in Z-Richtung bewegbar. Die Z-Korrektureinrichtung 18 ist hier eine Steuereinrichtung, die die Bewegung der Lötbäder oder Düsenanordnungen in Z-Richtung korrigiert.

Die Beschickungseinrichtung ist in diesem Ausführungsbeispiel ein Greifer-Achsensystem. Zusätzlich können die Positionierrahmen 12 mit einem Pneumatik-Schieber versehen sein, welcher einen Werkstückträger bzw. einen produktspezifischen Einlegerahmen in die Lötposition schiebt.

Jeder der Positionierrahmen 12 ist einer der Wellenlötvorrichtungen 9 zugeordnet. Somit ist die in einem Positionierrahmen 12 eingesetzte Leiterplatte der jeweiligen Wellenlötvorrichtung 9 zugeordnet. Der nicht näher dargestellte Aufbau der Wellenlötvorrichtungen 9 wird nun kurz beschrieben. Jede der Wellenlötvorrichtungen 9 weist ein Lötbad mit einer Heizeinrichtung zum Erhitzen des Lotes auf. Im Lötbad ist eine Lötdüsenanordnung angeordnet, wobei die Lötdüsenanordnung eine oder mehrere Wellenlötdüsen umfassen kann. Das Lötbad weist eine Lotpumpe mit z.B. einem elektrodynamischen Pumpenantrieb auf, mit welcher flüssiges Lot durch einen jeweiligen Lotkanal jeder Lötdüse förderbar ist. Die Lotkanäle sind senkrecht (in Z-Richtung 11) angeordnet, sodass die Schwerkraft gegen die Förderrichtung der Lotpumpe wirkt. Im Betrieb fördert die Lotpumpe flüssiges Lot durch die Lotkanäle der Lötdüsen, sodass am oberen Randbereich der Lötdüsen flüssiges Lot austritt und eine Lotwelle oder Lötwelle (Miniwelle) bildet. Das Lot fließt dann an einer Außenwand der Lötdüsen wieder in das Lötbad zurück. Die Höhe der Lotwelle kann unter Einsatz eines Lasermikrometers geregelt werden, wie es z.B. aus der DE 102 43 769 A1 bekannt ist. Zur Vermeidung von Verschmutzungen der Lötung und von Lötfehlern kann vorgesehen sein, dass sich das Lötbad und ein Austrittsbereich der Lötdüsen in einer Schutzgasatmosphäre befinden. Nähert sich ein Lötgut wie etwa eine in einen Positionierrahmen 12 eingesetzte Baugruppe einer Wellenlötvorrichtung 9 an oder umgekehrt, wird die Lotwelle irgendwann die Unterseite des Lötgutes berühren, dann beginnt der eigentliche Lötvorgang. Dabei bleibt die erforderliche Lotmenge an den vorgesehenen Lötstellen des Lötgutes haften, während das überschüssige Lot in das Lötbad zurückfließt. Vorzugsweise weist das Lötbad eine Lotpegelregelung auf welche mittels eines Sensors den Lotstand misst und eine automatische Lotdrahtzufuhr derart steuert, dass das Lotniveau etwa konstant bleibt.

Nach Einsetzen der Leiterplatte in den vorgesehenen Positionierrahmen 12 beginnt der Lötvorgang durch ein vorbestimmtes Lötprogramm. Dabei wird die Leiterplatte durch die optionale Oberheizung 10 unter Einsatz eines optionalen Pyrometers (nicht näher dargestellt) der zugeordneten Wellenlötvorrichtung 9 auf Temperatur gehalten. Das Lötprogramm umfasst ein wiederholtes Zustellen (Hochfahren) und Absetzen (Absenken) der Lötdüsen in Z-Richtung 11 und ein wiederholtes Bewegen des Lotbadtisches 6 in X-Y-Richtung 7, 8. Dabei ist festzuhalten, dass die Positionierrahmen 12 in X-Y-Richtung feststehen und die Abarbeitung der Lötfolge durch Bewegen des Lotbadtisches 6 in der X-Y-Ebene erfolgt. Die Lötungen können einzeln für jede Lötstelle durchgeführt werden, oder es können mehrere Lötstellen in einem Zug gelötet werden. Für jede Lötung werden die entsprechenden Lötdüsen zugestellt und zurückgefahren. Der Weg in Z-Richtung zwischen zwei Lötungen kann dabei sehr gering sein.

Die Bewegung des Lotbadtisches 6 ist dabei zyklisch, und es ist grundsätzlich beliebig, an welcher Stelle eines Zyklus der Lötvorgang beginnt und endet. Es kann also eine Leiterplatte zu einem beliebigen Zeitpunkt in einen Positionierrahmen 12 eingesetzt werden, und nach Zustellen der Lötdüsen der zugeordneten Wellenlötvorrichtung 9 beginnt der Lötvorgang an der Stelle, an der sich das Lötprogramm bzw. der Lötzyklus gerade befindet. Es können daher die Positionierrahmen 12 nacheinander beschickt werden, und das Lötprogramm kann für jeden Positionierrahmen 12 bzw. für die darin jeweils angeordnete Leiterplatte an einer anderen Stelle beginnen. Die Leiterplatten bzw. Baugruppen können somit zeitlich versetzt bzw. asynchron in die Positionierrahmen 12 eingesetzt werden.

Bei Wechsel einer Leiterplatte kann das Lötprogramm die X-Y-Bewegung des Lotbadtisches 6 kurzzeitig unterbrechen oder verlangsamen, um ein optimales Ablösen der Lotwelle von der Leiterplatte und einen Lötbeginn für die neue Leiterplatte zu verwirklichen; dabei können die Lötdüsen der anderen Wellenlötvorrichtungen 9 kurzzeitig zurückgefahren werden, um eine Überhitzung von Lötstellen zu vermeiden, sofern dies erforderlich sein sollte. Das Lötprogramm selbst wird in einer Endlosschleife abgearbeitet und die Z-Achsen der jeweiligen Lotbäder düsenabhängig für einen kompletten Programmdurchlauf eingebunden.

Wenn das Lötprogramm bzw. der Lötzyklus für eine Leiterplatte beendet ist, wird die Lötdüsenanordnung der zugeordneten Wellenlötvorrichtung 9 zurückgefahren und so die Lotwelle von der Leiterplatte getrennt. Die Beschickungseinrichtung ergreift die Leiterplatte und führt sie zunächst der Prüfeinrichtung 20 zu (Bewegungsrichtung 27). Die Prüfeinrichtung 20 ist zur automatischen optischen Prüfung bzw. Inspektion (AOI) der Leiterplatte eingerichtet und dient der Kontrolle der Lötstellengüte. Nach erfolgter Prüfung wird die Leiterplatte auf den Auslauf-Förderer 5 gesetzt und der dort vorgesehenen ersten Kühlstufe 16 zugeführt (Bewegungsrichtung 28), in welcher eine direkte Kühlung durch ein Kühlaggregat erfolgt. Von der ersten Kühlstufe 16 aus wird die Leiterplatte der zweiten Kühlstufe 17 zugeführt (Bewegungsrichtung 29). Die zweiten Kühlstufe 17 entspricht einem lüftergekühlten Kühltunnel, den die Leiterplatte durchläuft. Von der zweiten Kühlstufe 17 aus wird die Leiterplatte einer Auslaufstelle 31 zugeführt (Bewegungsrichtung 30). Auch das Entfernen der Leiterplatten bzw. Baugruppen vom Positionierrahmen 12 erfolgt zeitlich versetzt bzw. asynchron.

Der gesamte Prozess der Förderung, Beschickung, Z-Korrektur und Ausrichtung der Leiterplatten, Temperaturführung der Leiterplatten im Einlauf, während des Lötvorgangs und im Auslauf, Temperaturführung, Förderung und Wellenhöheregelung des Lots, X-Y-Führung des Lotbadtisches 6, Z-Führung der Lötdüsen, Güteprüfung (AOI) wird von einer im Schaltschrank 5 befindlichen Steuereinrichtung gesteuert. Die Anlage 1 ist von einer Wartungsseite 32 aus für Wartungen zugänglich. Optional kann für Wartungszwecke der Schaltschrank in Richtung der Wartungsseite 32 bewegbar sein (nicht näher dargestellt).

Nach dem Ausführungsbeispiel wird die Relativbewegung von Leiterplatten und Lötdüsen in Z-Richtung 11 durch Zustellen (also Hochfahren) des Lötbades und damit der Lötdüsen verwirklicht. Alternativ dazu kann ein Absenken des Positionierrahmens 12 in Z-Richtung 11 vorgesehen sein. Die Positionierrahmen können vorzugsweise individuell in Z-Richtung bewegt werden, so dass jeder Positionierrahmen, der jeweils eine Baugruppe aufnehmen kann, unabhängig von den anderen Positionierrahmen einer Wellenlötvorrichtung zugestellt wird. Es können jedoch auch alle Positionierrahmen gleichzeitig auf- und abbewegbar sein. Dann werden zum Einlegen oder Abnehmen einer Baugruppe kurzzeitig alle Positionierrahmen von den jeweiligen Wellenlötvorrichtungen entfernt bzw. wieder herangeführt. Die Bewegungsformen des Bewegens der Lötdüsen bzw. des Bewegens des Positionierrahmens können auch kombiniert sein.

Nach dem Ausführungsbeispiel wird die Relativbewegung von Baugruppen und Lötdüsen in der X-Y-Ebene durch eine Bewegung des Lotbadtisches 6 verwirklicht. Eine relative Bewegung zwischen Düsen und Baugruppen kann auch von den Baugruppen bzw. den sie tragenden Positionierrahmen ausgeführt werden und die Düsen können ortsfest angeordnet sein. Es ist auch möglich, dass die Düsen gemeinsam in einem Lötbad bewegt werden. Unabhängig davon, welches Element (Lotbad, Düsen, Positionierrahmen) bewegt wird, ist immer nur eine Bewegungseinrichtung notwendig, um mehrere Baugruppen gleichzeitig selektiv löten zu können.

Die Lötdüsenanordnung einer Wellenlötvorrichtung 9 kann eine einzige Düse oder mehrere Düsen aufweisen. Falls mehrere Düsen vorgesehen sind, können diese gleich sein oder unterschiedliche Form und/oder unterschiedliche Durchmesser aufweisen. Besonders vorteilhaft ist der Einsatz beloteter oder teilbeloteter Düsen. Teilbelotete Düsen erlauben unter anderem einen Lotablauf mit Vorzugsrichtung und eine definierte Lötspurbreite. Diese Wirkung kann auch durch besondere Düsengeometrien verwirklicht oder verstärkt werden. Der Aufbau von Lötdüsen mit Vorzugsrichtung ist beispielsweise in dem deutschen Gebrauchsmuster DE 20 2011 050 852 U1 der Anmelderin beschrieben, auf dessen Inhalt hiermit Bezug genommen wird. Zur Ausnutzung der Richtwirkung und definierten Lötspurbreite kann eine Düsendreheinrichtung zum Drehen der Düsen um 90° vorgesehen sein.

Es kann auch zweckmäßig sein, die Baugruppen mit einem vorbestimmten Neigungswinkel bzgl. der X-Y-Ebene anzuordnen. Hierzu wird eine Einrichtung zum Kippen der Baugruppen in den Positionierrahmen 12 oder zum Kippen der Positionierrahmen 12 selbst vorgesehen. Durch den Winkel der Leiterplatte zur Horizontalen kann ein optimaler Ablauf des Lots bzw. Lotabriss an der zu lötenden Stelle auf der Leiterplatte verwirklicht werden. Kippwinkel in der Größenordnung zwischen 5° und 15° haben sich als geeignet herausgestellt, wobei die Ablaufgeschwindigkeit mit wachsendem Kippwinkel wächst. Ein Kippwinkel zwischen 7° und 12° hat sich als gut kontrollierbar herausgestellt.

Wenn nun der Lotbadtisch, dem Lötprogramm folgend, in Richtung der Neigung verfahren wird, kann der Abstand zwischen Lotwelle und Leiterplatte durch synchronisiertes Zustellen oder Zurückfahren der Lötdüsen in Z-Richtung 11 konstant gehalten werden. Alternativ können die Positionierrahmen 12 in Z-Richtung 11 bewegbar eingerichtet sein, um den Abstand zwischen Lotwelle und Leiterplatte konstant zu halten.

Diese Anordnung kann in einer Abwandlung an den Einsatz richtungsbevorzugter Düsen angepasst werden. Um ein Löten in bestimmten lokalen (auf die Leiterplatte bezogenen) X- und Y-Richtungen unter Ausnutzung des Kippwinkels zu verwirklichen, kann zusätzlich eine Dreheinrichtung zum Drehen der Leiterplatte und/oder der jeweiligen Düse gegenüber dem Lötbad um einen vorbestimmten Winkelbereich von z.B. 0°bis 90° vorgesehen sein.

In dem Ausführungsbeispiel sind für die verschiedenen Einrichtungen beispielhafte Auswahlen getroffen, die, soweit es im Einzelfall nicht anders angegeben ist, die Erfindung und ihren Anwendungsbereich nicht beschränken. Anstelle eines Sprühfluxers 13 kann ein Tropfenfluxer oder Ultraschallfluxer vorgesehen sein. Die Vorheizstufen 14, 15 können anstelle von Strahlerheizung andere Heizverfahren verwenden, wie etwa eine Wendelheizung oder eine Infrarot-Strahlungsheizung. Die Vorheizstufen 14, 15 können unterschiedlich aufgebaut sein. Die Kühlstufen 16, 17 können auf andere als die beschriebenen Kühlverfahren zurückgreifen.

In einer Abwandlung des vorliegenden Ausführungsbeispiels weisen die Wellenlötvorrichtungen 9 unterschiedliche Düsenarten wie etwa unterschiedliche Düsendurchmesser oder Düsenbauarten auf und wird die Leiterplatte nach Durchlaufen eines Lötzyklus der einen Wellenlötvorrichtung 9 durch die Beschickungseinrichtung zu einem Positionierrahmen 12 einer anderen Wellenlötvorrichtung 9 mit anderer Düsenart umgesetzt (nicht näher dargestellt). Durch intelligentes Beschicken abhängig von den eingesetzten Düsendurchmessern und aktiven bzw. betriebsbereiten Lotbädern kann der Prozess weiter optimiert werden.

Zusätzlich oder alternativ zu einer Z-Korrektur kann auch eine Fiducial-Korrektur vorgesehen sein. Hierbei wird eine Ausrichtung an Referenzpunkten etwa durch Laser-Verfahren oder Kameras vorgenommen. Mit einer solchen Fiducial-Korrektur werden vorbestimmte Markierungen, die Fiducials, auf einer Leiterplatte abgetastet und deren Position bzgl. X- und Y-Richtung bestimmt. In Abhängigkeit der gemessenen Positionen der Fiducials wird die zu lötende Baugruppe in X- und Y-Richtung (= horizontale Richtungen) ausgerichtet und im Lötbereich positioniert. Wenn die Lötdüsenanordnungen unabhängig voneinander ansteuerbar sind oder wenn deren Position in X- und Y-Richtung relativ zueinander korrigierbar ist, dann kann auch die Position der Lötdüsenanordnung in Abhängigkeit der gemessenen Positionen der Fiducials entsprechend korrigiert werden.

In Fign. 2A bis 2F sind Varianten einer Lotbadanordnung in der Lötanlage von Fig. 1 schematisch dargestellt. Dabei entspricht Fig. 2A als Ausgangspunkt im Wesentlichen der Anordnung in Fig. 1, wobei nur der Lotbadtisch 6 mit den drei Wellenlötvorrichtungen 9 und die zugeordneten drei Positionierrahmen 12 nebst Schaltschrank 5 dargestellt sind.

In einer Variante gemäß Fig. 2B sind nur zwei statt dreier Wellenlötvorrichtungen 9 auf dem Lotbadtisch 6 und dementsprechend nur zwei Positionierrahmen 12 vorgesehen. Damit können zwei Baugruppen gleichzeitig gelötet werden. Die Positionierrahmen 12 und die Oberheizungen 10 sind in dieser Variante größer ausgelegt und können daher größere Baugruppen als in der Variante von Fig. 2A aufnehmen.

In einer Variante gemäß Fig. 2C sind sechs Wellenlötvorrichtungen 9 auf dem Lotbadtisch 6 und dementsprechend sechs Positionierrahmen 12 für sechs Baugruppen vorgesehen. Die Größe der Positionierrahmen 12 entspricht derjenigen der ursprünglichen Variante gemäß Fig. 2A. Um sechs Wellenlötvorrichtungen auf der gleichen Gestellgröße unterzubringen, sind zwei Reihen von je drei Wellenlötvorrichtungen 9 jeweils um 90° gegenüber der Variante gemäß Fig. 2A gedreht angeordnet. Um hierfür Platz zu schaffen, ist der Schaltschrank an die ursprüngliche Wartungsseite (32 in Fig. 2A) versetzt worden. Die Wellenlötvorrichtungen 9 sind jeweils von einer von zwei Wartungsseiten 32 aus zugänglich.

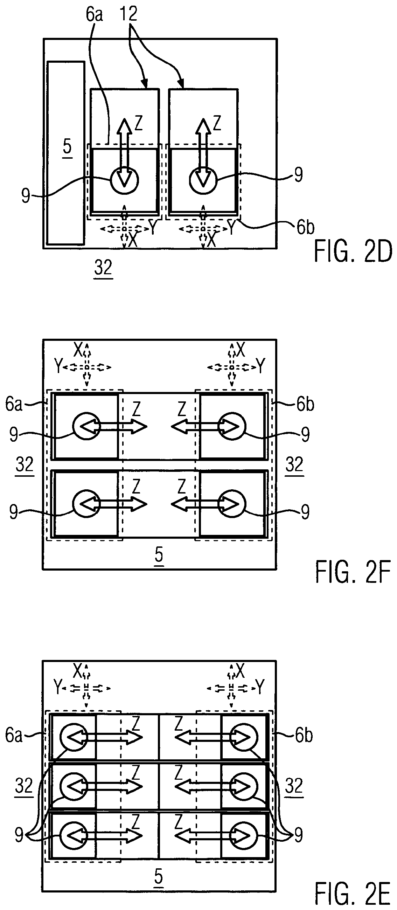

Eine Variante gemäß Fig. 2D entspricht derjenigen in Fig. 2B darin, dass zwei Wellenlötvorrichtungen 9 und zwei Positionierrahmen 12 vorgesehen sind. Sie unterscheidet sich darin, dass jede der Wellenlötvorrichtungen 9 auf einem eigenen Lotbadtisch 6a, 6b angeordnet ist, und dass jeder Lotbadtisch 6a, 6b getrennt von dem anderen in X- und Y-Richtung bewegbar ist. Damit können zwei Baugruppen gleichzeitig mit unterschiedlichen Lötprogrammen gelötet werden.

Eine Variante gemäß Fig. 2E entspricht derjenigen in Fig. 2C darin, dass sechs Wellenlötvorrichtungen 9 und sechs Positionierrahmen 12 in zwei Reihen vorgesehen sind. Sie unterscheidet sich darin, dass jeweils drei der Wellenlötvorrichtungen 9 auf einem eigenen Lotbadtisch 6a, 6b angeordnet sind, und dass jeder Lotbadtisch 6a, 6b getrennt von dem anderen in X- und Y-Richtung bewegbar ist. Damit können zwei Gruppen von je drei Baugruppen, also insgesamt sechs Baugruppen gleichzeitig mit zwei unterschiedlichen Lötprogrammen gelötet werden.

Eine Variante gemäß Fig. 2F ist eine Kombination der Varianten von Fign. 2E und 2B. D.h., dass zwei Reihen von Wellenlötvorrichtungen 9 auf jeweils einem Lotbadtisch 6a, 6b angeordnet sind, wobei die Reihen gegenüber angeordnet sind und jeder Lotbadtisch 6a, 6b getrennt von dem anderen in X- und Y-Richtung bewegbar ist, und dass jede Reihe aus zwei statt drei Wellenlötvorrichtungen 9 besteht und die zugeordneten (vier) Positionierrahmen 12 größer als diejenigen der Variante gemäß Fig. 2E sind. Damit können zwei Gruppen von je zwei (größeren) Baugruppen gleichzeitig mit zwei unterschiedlichen Lötprogrammen gelötet werden.

Es ist festzuhalten, dass in den Varianten gemäß Fign. 2A bis 2C ein einziger Lotbadtisch 6 mit XY-Antrieb vorgesehen ist, während in den Varianten gemäß Fign. 2D bis 2F jeweils zwei Lotbadtische 6a, 6b vorgesehen sind, die jeweils über einen eigenen XY-Antrieb verfügen. Die Lötprogramme für die Lotbadtische 6a, 6b können unterschiedlich sein und werden unabhängig voneinander abgearbeitet. Dabei ist die in Schaltschrank 5 untergebrachte Steuerung so ausgelegt, dass Kollisionen verhindert werden.

In den Fign. 3A bis 3F sind mögliche Konfigurationen des Transportsystems als Varianten des in Fig. 1 gezeigten Ausführungsbeispiels schematisch dargestellt. Dargestellt ist jeweils nur eine Förderseite mit Einlauf- und Auslauf-Förderer 3, 4 mit Pfeilen, welche eine Einlaufrichtung 33 und eine Auslaufrichtung 34 angeben, die jeweilige Einlauf- und Auslaufstelle 21, 31, eine Gruppe von drei Positionierrahmen 12, die symbolisch für eine Bearbeitungsseite steht und alle in Fign. 2A bis 2F gezeigten und weitere Anordnungsvarianten umfasst, und nicht näher bezeichnete Beschickungspfeile von der Förderseite zu der Bearbeitungsseite und umgekehrt. Die Beschickungspfeile entsprechen der Handhabung durch die nicht näher dargestellte Beschickungseinrichtung. Von der Förderseite zur Bearbeitungsseite weisende Pfeile entsprechen dabei den Pfeilen 25 und 26 in Fig. 1, und von der Bearbeitungsseite zur Förderseite weisende Pfeile entsprechen den Pfeilen 27 und 28 in Fig. 1.

Fig. 3A zeigt schematisch ein Inline-Transportsystem, bei welchem eine Einlaufstrecke und eine Auslaufstrecke in einem durchlaufenden Einlauf- und Auslauf-Förderer 3/4 zusammengefasst sind. Die Einlaufstelle 21 und die Auslaufstelle 31 befinden sich an gegenüberliegenden Seiten der Anlage.

Fig. 3B zeigt schematisch ein Batch- oder Doppelspur-Transportsystem, bei welchem der Einlauf-Förderer 3 und der Auslauf-Förderer 4 nebeneinander mit gegenläufigen Transportrichtungen 33, 34 angeordnet sind. Die Einlaufstelle 21 und die Auslaufstelle 31 befinden sich an der gleichen Seite der Anlage nebeneinander. Diese Variante entspricht der Anordnung in Fig. 1.

Fig. 3C zeigt schematisch ein Sandwich-Transportsystem, bei welchem der Einlauf-Förderer 3 und der Auslauf-Förderer 4 übereinander mit gegenläufigen Transportrichtungen 33, 34 angeordnet sind. Die Einlaufstelle 21 und die Auslaufstelle 31 befinden sich an der gleichen Seite der Anlage übereinander.

Fig. 3D zeigt schematisch ein Sandwich-Transportsystem mit Kipptransport, bei welchem der Einlauf-Förderer 3 und der Auslauf-Förderer 4 übereinander angeordnet sind. Die Einlaufstelle 21 und die Auslaufstelle 31 befinden sich an der gleichen Seite der Anlage übereinander. Die Beladung der Baugruppen erfolgt mit einer Kippung (nicht näher dargestellt).

Fig. 3E zeigt schematisch ein Inline-Transportsystem mit Doppelspur, bei welchem der Einlauf-Förderer 3 und der Auslauf-Förderer 4 nebeneinander angeordnet sind, aber gleiche Förderrichtungen 33, 34 aufweisen. Die Einlaufstelle 21 und die Auslaufstelle 31 befinden sich an gegenüberliegenden Seiten der Anlage. Im Vergleich zum einspurigen Inline-Transportsystem gemäß Fig. 3A können die Einlaufstrecke und die Auslaufstrecke länger sein. Insbesondere auf der Auslaufstrecke kann sich hierdurch ein Kühlpuffer ergeben.

Fig. 3F zeigt schematisch ein Batch- oder Doppelspur-Transportsystem für Taktbetrieb. Dabei sind wie in Fig. 3B der Einlauf-Förderer 3 und der Auslauf-Förderer 4 nebeneinander mit gegenläufigen Transportrichtungen 33, 34 angeordnet sind, und die Einlaufstelle 21 und die Auslaufstelle 31 befinden sich an der gleichen Seite der Anlage nebeneinander. Für die Beladung im Taktbetrieb ist die Beschickungseinrichtung mit einer dreifachen Greiferanordnung (je ein Greifer für jeden Positionierrahmen 12) versehen. Somit können jeweils drei Baugruppen gleichzeitig beschickt bzw. entnommen werden. Optional können Fluxer und Vorheizstufen jeweils dreifach oder dreisträngig ausgelegt werden, sodass alle Baugruppen bei Beschickung gleichmäßig benetzt und temperiert sind.

Da die Inline- und Sandwich-Transportsysteme gemäß Fign. 3A, 3C und 3D eine größere Förderbreite erlauben, ermöglichen sie bei gleicher Stellfläche die Handhabung größerer Baugruppen als die Doppelspursysteme gemäß Fign. 3B, 3E und 3F.

Mit einer Lötanlage 1 gemäß dem beschriebenen Ausführungsbeispiel, seinen Abwandlungen und Varianten kann ein Selektivlötprozess mit hohem Durchsatz verwirklicht werden. Es können mehrere Baugruppen gleichzeitig gelötet werden, wobei nur ein einziger Greifer benötigt wird, da die Baugruppen nacheinander in den Lötzyklus einsteigen können. Die Positionierrahmen 12 können starr, jedenfalls in der XY-Ebene, ausgelegt werden; somit sind XY-Antriebe für die einzelnen Positionierrahmen 12 nicht erforderlich. Daher können auch mechanische Einwirkungen auf die Baugruppen, die mit einem Verfahren der Baugruppen bzw. der Positionierrahmen 12 selbst verbunden sein könnten, vermieden werden. Die Anlage 1 ist so auslegbar, dass alle herkömmlichen Konfigurationen möglich sind. Bekannte Verfahrensoptionen wie Flussmittelmengenmessung, Vorheizung mit Pyrometer, Oberheizung mit Pyrometer, Automatische Optische Inspektion, Z-Korrektur, Teachen mittels Kamera, Fiducialkorrektur (Referenzpunktkorrektur), Visualisierung des Lötprozesses, Wellenhöhenregelung mittels Lasermicrometer, direktes Baugruppenhandling, Baugruppenkühlung und OTP (Offline-Teach-Programm) sind je nach Bedarf konfigurierbar. Die Einrichtungen für die Vor- und Nachbereitung der zu lötenden bzw. gelöteten Baugruppen müssen nur jeweils einmal vorgesehen werden.

Eine Prozessführung mit Kippen der Baugruppen und/oder Drehen kann vorgesehen werden. Hierdurch wird auch der Einsatz von nicht beloteten Düsen unter einem vorbestimmten Kippwinkel möglich. Es sind alle bekannten Transportsystemkonfigurationen wie Inline-, Batch-, Doppelspur-, Sandwitch- und Kipptransport im seriellen wie im Taktbetrieb mit oder ohne Handlingroboter von Baugruppen oder Werkstückträgern möglich. Auch eine Beschickung der Lotbäder mittels Transportshuttle ist möglich.

Figur 4 zeigt ein weiteres Ausführungsbeispiel einer Lötanlage 1, die wiederum ein Gestell 2 mit einem Einlauf-Förder 3, einem Schaltschrank 5, einem Lotbadtisch 6, der in X-Richtung 7 und in Y-Richtung 8 gegenüber dem Gestell 2 bewegbar ist, aufweist. Auf dem Lotbadtisch 6 sind drei Wellenlötvorrichtungen 9 angeordnet, die jeweils über eine Oberheizung 10 verfügen. Weiterhin weist die Lötanlage 1 eine Flußmittel-Benetzungseinrichtung (Fluxer) 13, eine erste Vorheizeinrichtung 14, eine zweite Vorheizeinrichtung 15, eine erste Kühlstufe 16 und eine zweite Kühlstufe 17 auf. Sofern im Folgenden nichts anderes ausgeführt ist, sind die einzelnen Teile bzw. Stationen der Lötanlage 1 dieses Ausführungsbeispiels genauso wie bei dem in Figur 1 gezeigten ersten Ausführungsbeispiel ausgebildet.

Dieses Ausführungsbeispiel unterscheidet sich von dem in Figur 1 gezeigten Ausführungsbeispiel dadurch, dass die Beschickungseinrichtung einen Schlitten bzw. Shuttle 35 aufweist. In Figur 4 ist der Schlitten 35 schematisch im Bereich benachbart zum Einlauf-Förderer 3 dargestellt. Der Einlauf- Förderer 3 ist eine Fördereinrichtung mit zum Beispiel zwei umlaufenden Förderbändern oder Stiftketten, auf welchen die Baugruppen unmittelbar oder mittels eines Baugruppenträgers aufliegen und geradlinig befördert werden. Der Schlitten 35 ersetzt den Auslauf-Förderer des Ausführungsbeispieles aus Figur 1 und ist parallel zum Einlauf-Förderer 3 hin und her (Doppelpfeil 36) verfahrbar. Der Schlitten 35 weist ein Paar Förderbänder (nicht dargestellt) auf, die quer zu seiner Bewegungsrichtung 36 angeordnet sind. Weiterhin weist der Schlitten 35 ein weiteres Paar Förderbänder auf, die zwischen den Förderbändern des Einlauf-Förderers 3 angeordnet sind und auf ein Niveau oberhalb der Förderbänder des Einlauf-Förderers 3 angehoben bzw. auf ein Niveau unterhalb der Förderbänder des Einlauf-Förderers 3 abgesenkt werden können. Hierdurch ist es möglich einzelne Baugruppen vom Einlauf-Förderer 3 abzuheben und auf den Schlitten 35 zu verfahren. Die Förderbänder des Schlittens 35, die sowohl auf dem Schlitten als auch im Bereich des Einlauf-Förderers 3 vorgesehen sind, werden im folgenden als Querförderbänder bezeichnet. Da der Schlitten 35 mit den Querförderbändern in Richtung 36 hin und her verfahrbar ist und an bestimmten Stellen angehalten werden kann, kann mit dem Schlitten an einer jeden beliebigen Stelle des Einlauf-Förderers eine Baugruppe von dieser abgezogen und auf den Schlitten 35 verfahren werden. Im Bereich des Einlauf-Förderers befinden sich die Stationen Flußmittel-Benetzungseinrichtung 13, erste Vorheizeinrichtung 14, zweite Vorheizeinrichtung 15, erste Kühlstufe 16, zweite Kühlstufe 17. Weiterhin können mit dem Schlitten 35 die Baugruppen auch vom Schlitten 35 einer der Stationen im Bereich des Einlauf-Förderers 3 zugeführt werden. Die den jeweiligen Lötbädern 9 zugeordneten Positionierrahmen 12 sind benachbart zum Bewegungsbereich des Schlittens 35 angeordnet. Im vorliegenden Ausführungsbeispiel sind die Positionierrahmen 12 als Förderbänder ausgebildet, so dass eine auf dem Schlitten 35 befindliche Baugruppe an jeweils einen der Positionierrahmen 12 übergeben werden kann und von diesem der Wellenlötvorrichtung 9 zugeführt wird.

Im Bewegungsbereich des Schlittens 35 ist eine Anlernvorrichtung 19 und eine Prüfeinrichtung 20 angeordnet.

Bei dieser Lötanlage 1 werden zu lötende Baugruppen an der Einlaufstelle 21 dem Einlauf-Förderer 3 übergeben. An der Flußmittel-Benetzungseinrichtung 13 werden sie zunächst mit Flußmittel benetzt, dann mittels des Einlauf-Förderers 3 zur ersten Vorheizstufe 14 und dann zur zweiten Vorheizstufe 15 befördert, wo sie jeweils aufgeheizt werden. Danach wird der Schlitten 35 in eine Position benachbart zur zweiten Vorheizstufe 15 gebracht. Die Querförderbänder im Bereich des Einlauf-Förderers 3 werden angehoben und die Baugruppe wird aus der zweiten Vorheizstufe 15 auf den Schlitten 35 verfahren. Der Schlitten 35 kann im Bereich der Anlernvorrichtung 19 positioniert werden, wenn ein neuer Typ von Baugruppe gelötet werden soll. Der Schlitten 35 kann benachbart zu einem beliebigen der drei Positionierrahmen 12 positioniert werden und die zu lötende Baugruppe wird dann vom Schlitten 35 auf den Positionierrahmen 12 befördert. Der Positionierrahmen fördert dann die Baugruppe zur Wellenlötvorrichtung 9, in welcher dann der Lötvorgang ausgeführt wird.

Die Bewegungsrichtung 37 (Figur 5) der Baugruppe verzweigt somit zu den einzelnen Lötbädern. Mit den Schlitten 35 können somit zu beliebigen Zeitpunkten Baugruppen den Wellenlötvorrichtungen 9 zugeführt oder von diesen abgezogen werden.

Nach dem Lötvorgang werden die gelöteten Baugruppen von den Positionierrahmen 12 auf den Schlitten 35 zurück übergeben mit diesem der ersten Kühlstufe 16 zugeführt. Von der zweiten Kühlstufe 17 werden die Baugruppen unmittelbar an der benachbarten Auslaufstelle 31 abgeführt. Wenn jedoch nach dem Löten in der Prüfeinrichtung 20 festgestellt wird, dass ein Fehler vorliegt, dann wird die Baugruppe mit dem Schlitten 35 zu einer Schlechtteilablage bzw. einer Reparaturstation 46 verfahren.

Bei dem in Figur 4 gezeigten Ausführungsbeispiel werden die Lötdüsenanordnungen der Wellenlötvorrichtung 9 synchron zueinander bewegt. Grundsätzlich ist es auch möglich, die Bewegungseinrichtung für die einzelnen Lötdüsenanordnungen der einzelnen Wellenlötvorrichtungen 9 unabhängig voneinander auszubilden. Bei einer solchen Ausführungsform können in den einzelnen Wellenlötvorrichtungen 9 unterschiedliche Baugruppen gleichzeitig gelötet werden. Bei einer Baugruppe mit wenigen Lötstellen ist der Lötvorgang wesentlich schneller abgeschlossen als bei einer Baugruppe mit vielen Lötstellen. Dadurch kann es sein, dass Baugruppen, die erst später an der Einlaufstelle 21 der Lötanlage 1 zugeführt werden dennoch früher an der Auslaufstelle 31 von der Lötanlage 1 abgegeben werden als andere Baugruppen. Diese Beschickungseinrichtung mit einem Schlitten 35 erlaubt somit ein Überholen einzelner Baugruppen innerhalb der Lötanlage 1. Hierdurch ist die Lötanlage 1 hoch flexibel und die einzelnen Stationen können optimal ausgelastet werden.

Bei einer solchen Lötanlage 1 mit mehreren voneinander unabhängigen Wellenlötvorrichtungen 9, bei welchen die Düsenanordnungen jeweils unabhängig voneinander bewegt werden können, ist es zweckmäßig eine Einrichtung zur Produkterkennung durch bspw. ein Kamerasystem, einen Barcodeleser, einer Leseeinrichtung zum Lesen einer Werkstückträgercodierung (z.B. Lichtschranke), ein Transpondersystem a der Einlaufstelle 21 vorzusehen, um die folgenden Prozesse wie Fluxen, Vorheizen und Löten produktspezifisch abzuarbeiten. Hierbei werden automatisch die Abfolge der einzelnen Bearbeitungsschritte und die Parameter der jeweiligen Bearbeitungsschritte eingestellt.

Figur 6 zeigt ein weiteres Ausführungsbeispiel einer erfindungsgemäßen Lötanlage 1 mit zwei Wellenlötvorrichtungen 9 mit jeweils einer Oberheizung 10. Die beiden Wellenlötvorrichtungen 9 weisen jeweils eine Lötdüsenanordnung auf, die voneinander unabhängig bewegbar sind. An einer Einlaufstelle 21 befindet sich ein Aufnahmepuffer 38, an welchen zu lötende Baugruppen angeliefert werden können. Die Lötanlage 1 weist weiterhin eine Flußmittel-Benetzungseinrichtung 13, einen Puffer 39, der benachbart zu einer Vorheizstufe 40 angeordnet ist. Benachbart zu einer Auslaufstelle 31 ist eine Kühlstufe 41 vorgesehen.

Als Beschickungseinrichtung ist in diesem Ausführungsbeispiel ein Greifer-Achsensystem vorgesehen, das sich über den Aufnahmepuffer 38, die Stationen 13, 39, 40, den Wellenlötvorrichtungen 9 und der Kühlstufe 41 erstreckt.

Eine im Aufnahmepuffer 38 zugeführte zu lötende Baugruppe wird von der Beschickungseinrichtung zunächst zur Flußmittel-Benetzungseinrichtung 13, von dort zum Puffer 39 befördert. Am Puffer 39 kann die zu lötende Baugruppe mittels eines Schiebers (nicht dargestellt) zur Vorheizstufe 40 verschoben werden. Anstelle eines solchen Schiebers kann auch die Beschickungseinrichtung verwendet werden, um die Baugruppe vom Puffer 39 zur Vorheizstufe 40 zu bewegen. Von der Vorheizstufe 40 wird die erhitzte Baugruppe zu einer der beiden Wellenlötvorrichtungen 9 mittels der Beschickungseinrichtung befördert (Pfeile 42). Hier verzweigt der Bewegungsweg der Baugruppen einmal zu der einen Wellenlötvorrichtung 9 und ein anderes Mal zu der anderen Wellenlötvorrichtung 9, wie es in Figur 6 anhand der beiden Pfeile 42 gezeigt ist. Nach dem Lötvorgang werden die gelöteten Baugruppen mit der Beschickungseinrichtung zur Kühlstufe 41 befördert. An der Kühlstufe 41 werden die Baugruppen abgekühlt und dann an der Auslaufstelle 31 ausgegeben.

Auch bei dieser Lötanlage 1 können unterschiedliche Typen von Baugruppen gleichzeitig mit den unterschiedlichen Lötvorrichtungen 9 gelötet werden, wobei aufgrund der Verzweigung des Bewegungsweges der Baugruppen ein Überholen innerhalb der Lötanlage 1 möglich ist.

Figur 7 zeigt grob schematisch vereinfacht einen Ausschnitt einer weiteren Lötanlage mit drei Wellenlötvorrichtungen 9 die geradlinig nebeneinander angeordnet sind. Auf der linken Seite in Figur 7 ist ein Einlauf-Förderer 3 und auf der rechten Seite in Figur 7 ein Auslauf-Förderer 4 dargestellt.

Oberhalb der Wellenlötvorrichtung 9 ist eine Beschickungseinrichtung 43 mit einem Greifer-Achsensystem gezeigt. Die Beschickungseinrichtung 43 weist eine Schiene 44 auf, die sich vom Bereich des Einlauf-Förderers 3 über die drei Wellenlötvorrichtungen 9 bis zum Auslauf-Förderer 4 erstreckt. Mit der Beschickungseinrichtung 43 kann eine zu lötende Baugruppe vom Einlauf-Förderer 3 angehoben und auf eine beliebige der drei Wellenlötvorrichtungen 9 abgesetzt werden.

Die Wellenlötvorrichtungen 9 sind jeweils Wellenlötvorrichtungen zum Selektivlöten, wobei die drei Wellenlötvorrichtungen unabhängig voneinander ausgebildet sind, so dass gleichzeitig unterschiedliche Lötprogramme an den einzelnen Wellenlötvorrichtungen 9 ausgeführt werden können. Eine gelötete Baugruppe wird von der Beschickungseinrichtung 43 von der jeweiligen Wellenlötvorrichtung 9 angehoben und zum Auslauf-Förderer 4 befördert. Der Bewegungsweg der Baugruppen ist mit dem Bezugszeichen 45 gekennzeichnet. Im Bereich oberhalb der jeweiligen Wellenlötvorrichtungen 9 verzweigt der sich vom Einlauf-Förderer 3 zum Auslauf-Förderer 4 erstreckende Bewegungsweg jeweils nach unten zur Wellenlötvorrichtung 9. Aufgrund dieser Verzweigung ist es wieder möglich, dass bestimmte Baugruppen andere Baugruppen innerhalb der Lötanlage überholen.

Bei den in Figur 4 bis 6 gezeigten Ausführungsformen erfolgt die Verzweigung des Bewegungsweges in der horizontalen Ebene. Bei der Ausführungsform nach Figur 7 erfolgt die Verzweigung des Bewegungsweges in der vertikalen Ebene.

Bei der Ausführungsform gemäß Figur 7 sind 3 Wellenlötvorrichtungen 9 vorgesehen. Diese Ausführungsform macht Sinn mit zumindest zwei Wellenlötvorrichtungen 9. Sie kann jedoch auch eine beliebige andere Anzahl von Wellenlötvorrichtungen 9 umfassen. Zur Vereinfachung der Darstellung wurden weitere Stationen zu Vor- und Nachbearbeitung in Figur 7 weggelassen. Diese werden zweckmäßigerweise in ähnlicher Weise wie bei den oben erläuterten Ausführungsbeispielen/Ausführungsformen hinzugefügt.
Die vorliegende Erfindung wurde vorstehend anhand mehrerer Ausführungsbeispiele und zahlreicher Varianten und Abwandlungen beschrieben. Es versteht sich, dass die Erfindung durch Einzelheiten der Beschreibung nicht beschränkt ist, sondern allein durch die Merkmale der unabhängigen Ansprüche in ihrer breitesten Auslegung und ihre Äquivalente definiert ist.

Bei einer Ausführungsform gemäß Figur 8 weist eine schematisch dargestellte Lötanlage 1 nach einem weiteren Ausführungsbeispiel der vorliegenden Erfindung eine Transport- bzw. Fördereinrichtung 48, einen Schaltschrank 5 mit einer Steuereinrichtung 47 und ein Gestell 2 mit einem Lotbadtisch 6 auf.

Der Lotbadtisch 6 ist in X-Richtung 7 und in Y-Richtung 8 gegenüber dem Gestell 2 bewegbar. Die X-Richtung 7 und die Y-Richtung 8 definieren eine horizontale Ebene.

Auf dem Lotbadtisch 6 sind zwei Wellenlötvorrichtungen 9 angeordnet, die jeweils über eine Oberheizung (nicht dargestellt) verfügen. Jede der Wellenlötvorrichtungen 9 bzw. eine nicht näher dargestellte Lötdüsenanordnung jeder der Wellenlötvorrichtungen 9 ist einzeln in Z-Richtung bewegbar. Die Z-Richtung ist lotrecht zur X-Y-Ebene und definiert somit die Vertikalrichtung. Zur Bewegung des Lotbadtisches 6 ist ein nicht näher dargestellter XY-Antrieb vorgesehen, der im Folgenden als Bewegungseinrichtung bezeichnet wird. Mit dieser Bewegungseinrichtung werden die beiden auf dem Lotbadtisch befindlichen Wellenlötvorrichtungen 9 synchron bewegt. Jeder Wellenlötvorrichtung 9 ist ein Lötbereich zugeordnet, innerhalb dem die Lötdüsen der jeweiligen Lötdüsenanordnung verfahrbar sind. Sowohl die X-Y-Bewegungsrichtungen des Lotbadtisches 6 als auch die Z-Bewegungsrichtungen der einzelnen Lotbäder 9 sind in der Zeichnungsebene dargestellt. Zur Bewegung der einzelnen Lotbäder in Z-Richtung ist ein Z-Antrieb vorgesehen, die im Folgenden als Koppeleinrichtung bezeichnet wird, da er zum Ein- und Auskoppeln einer Baugruppe in ein Lötprogramm dient, wie es unten näher erläutert wird.

Die Transporteinrichtung ist derart ausgebildet, dass die zu lötende Baugruppen sequentiell zu den Lötdüsenanordnungen befördert werden.

Die Steuereinrichtung steuert die Bewegungseinrichtung zur relativen Bewegung der Lötdüsen bzgl. der Baugruppen derart an, dass in einer Lötdüsenanordnung grundsätzlich das vollständige Lötprogramm für eine Baugruppe ausgeführt wird. Während der Ausführung des Lötprogramms kann jedoch eine Baugruppe aus einer in Bewegungsrichtung vorderen Wellenlötvorrichtung 9 ausgekoppelt werden und zur in Bewegungsrichtung folgenden Wellenlötvorrichtung bewegt werden und dort in das Lötprogramm eingekoppelt werden. Somit wird an einer Baugruppe an den einzelnen Wellenlötvorrichtungen oder Lötdüsenanordnungen 9 nur ein Teilabschnitt des Lötprogramms ausgeführt. Alle Teilabschnitte eines Lötprogramms werden an einer Baugruppe an den unterschiedlichen Lötdüsenanordnungen ausgeführt, so dass die Teilabschnitte zusammen das vollständiges Lötprogramm dieser Baugruppe darstellen.

Die Transporteienrichtung ist vorzugsweise linear ausgebildet.

Die Vorrichtung gemäß diesem weiteren Ausführungsbeispiel kann auch als Doppel- oder Mehrspur-Vorrichtung ausgebildet sein.

Insbesondere kann vorgesehen sein, dass zu lötende Baugruppen mittels der Transporteinrichtung sequentiell zu den Lötdüsenanordnungen befördert werden.

Dieser Erfindung liegt die Erkenntnis zugrunde, dass das Lötprogramm zyklisch ist und dass zu einem beliebigen Zeitpunkt begonnen werden kann, denn grundsätzlich ist es nicht entscheidend, welche Lötstellen zu Beginn bzw. am Ende des Lötprogrammes gelötet werden. Die einzelnen Baugruppen müssen nicht gleichzeitig, sondern können auch nacheinander in die Lötvorrichtung eingebracht und in den Lötbereich eingesetzt werden. Dadurch können die einzelnen Baugruppen aufeinander folgend der Vorbearbeitung (Auftragen von Flussmittel, Aufheizen, Lagekorrektur, Z-Korrektur) und der Nachbearbeitung (AOI, Kühlung) unterzogen werden. Dennoch ist es möglich, mehrere Baugruppen parallel zu löten.

Vorteilhaft ist gemäß dem Verfahren nach diesem weiteren Ausführungsbeispiel, dass in einer Lötdüsenanordnung lediglich ein Teilabschnitt des auszuführenden Lötprogrammes für eine Baugruppe ausgeführt wird. Das bedeutet wenn eine in Transportrichtung weiter vorne angeordnete erste Baugruppe zu Ende gelötet ist, dann ist es möglich das Lötprogramm einer dahinter angeordneten zweiten Baugruppe zu unterbrechen so dass nur ein Teilabschnitt des betreffenden Lötprogramms ausgeführt wird. Die erste Baugruppe kann dann entnommen werden. Anschließend wird die zweite Baugruppe zum Lötbad der ersten Baugruppe transportiert. Das unterbrochene Lötprogramm wird dann entsprechend fortgesetzt, so dass alle Teilabschnitte, die mit einer Baugruppe an den unterschiedlichen Lötdüsenanordnungen ausgeführt werden zusammen ein vollständiges Lötprogramm dieser Baugruppe darstellen. Auf diese Weise ist es möglich die hintere Position sofort wieder mit einer zu bearbeitenden Baugruppe zu besetzen, um dort ein neues Lötprogramm zu starten.

Somit ist es möglich ein äußerst effektives Verfahren zum Selektivlöten bzw. eine entsprechende Vorrichtung auszubilden.

Die Erfindung gemäß diesem weiteren Ausführungsbeispiel ist mit allen geeigneten weiteren Merkmalen der vorstehend beschriebenen Ausführungsbeispiele der vorliegenden Erfindung weiterbildbar.

Gemäß dieser Ausführungsform kann auch vorgesehen sein, dass das Lötprogramm einer Baugruppe in vereinzelten Ausnahmefällen, sofern dies aufgrund von weniger Durchlauf oder Leerlaufzeiten möglich ist, vollständig ausgeführt wird. Die Steuereinrichtung 47 steuert die Bewegungseinrichtung zur relativen Bewegung der Lötdüsen bzgl. einer Baugruppe derart an, dass in einer Lötdüsenanordnung das gesamte Lötprogrammm ausgeführt wird.

Bei einer weiteren Ausführungsform gemäß Figur 9 weist eine schematisch dargestellte Lötanlage 1 ähnliche Merkmale wie die in Figur 8 beschriebene Ausführungsform auf.

Gemäß dieser Ausführungsform ist die Lötanlage als Doppelspuranlage 1 bzw. als Mehrspuranlage ausgebildet (nicht dargestellt), welche zumindest eine Transporteinrichtung 48 mit zwei Spuren aufweist.

Zwei Lötdüsenanordnungen bzw. Wellenlötvorrichtungen 9 sind auf einem gemeinsamen Lotbadtisch 6 angeordnet. Diese beiden Wellenlötvorrichtungen 9 sind jeweils einer der beiden Spuren der Transporteinrichtung 48 zugeordnet.

Die Transporteinrichtung 48 ist derart ausgebildet, dass bspw. zwei zu lötende Baugruppen nebeneinander zu den Lötdüsenanordnungen 9 der ersten und der zweiten Spur befördert werden.

In beiden Spuren wird in den beiden Wellenlötvorrichtungen 9 das Lötprogramm synchron ausgeführt. Vorzugsweise sind in Längsrichtung der Transporteinrichtung aufeianderfolgend mehrere Wellenlötvorrichtungen 9 vorgesehen, welche auf dem selben oder auch auf unterschiedlichen Lotbadtischen 6 angeordnet sind.

Die Steuereinrichtung 47 steuert die Bewegungseinrichtung zur relativen Bewegung der Lötdüsen bzgl. einer Baugruppe derart an, dass in einer Lötdüsenanordnung lediglich ein Teilabschnitt eines auszuführenden Lötprogrammes für eine Baugruppe ausgeführt wird, oder aber auch das gesamte Lötprogrammm ausgeführt werden kann.

Die Lötanlagen 1 der Ausführungsbeispiele sind Lötvorrichtungen im Sinne der Erfindung, und die nicht näher dargestellten Baugruppen sind Beispiele für Baugruppen im Sinne der Erfindung. Eine Bewegungseinrichtung im Sinne der Erfindung kann durch den XY-Antrieb der Lotbadtische 6, 6a, 6b, eine nicht näher dargestellte Einrichtung zum Anheben oder Absenken der Lötdüsen der Wellenlötvorrichtungen 9, die nicht näher dargestellte Beschickungseinrichtung, Teile der Positionierrahmen 12, sowie weitere beschriebene oder angedeutete Bewegungselemente wie etwa eine Dreheinrichtung zum Drehen von Düsen oder Baugruppen, eine Kippeinrichtung zum Kippen der Baugruppen und dergleichen verwirklicht sein. Insbesondere können die X-Richtung 7, die Y-Richtung 8, die Z-Richtung 11 und die Bewegungsrichtungen 25, 26, 27, 28 als Ergebnis von Funktionen einer Bewegungseinrichtung im Sinne der Erfindung verstanden werden. Die Wellenlötvorrichtungen 9 sind Lötdüsenanordnungen, die Positionierrahmen 12 sind Baugruppenhalteeinrichtungen bzw. Baugruppenförder- und -positioniereinrichtungen und die Lotbadtische 6, 6a, 6b sind Bewegungseinheiten im Sinne der Erfindung.

Im Rahmen der Erfindung ist es auch möglich eine Bewegungseinrichtung zum synchronen relativen Bewegen zumindest einer Wellenlötvorrichtung und zumindest einer optischen Abtasteinrichtung einer AOI-Station vorzusehen. Nach dem Löten wird die Baugruppe der AOI-Station zugeführt. Die optische Abtasteinrichtung führt synchron mit der Wellenlötvorrichtung die gleichen relativen Bewegungen bzgl. der jeweiligen Baugruppe aus und tastet somit alle Lötstellen ab.

Eine optische Abtasteinrichtung kann eine Kamera oder ein Ende eines abbilden Lichtleiterbündels oder eine bewegliches Objektiv sein, das mit einer Kamera verbunden ist.

Bei allen oben erläuterten Ausführungsbeispielen kann eine Wellenlötvorrichtung durch eine solche AOI-Station (automatic optical inspection station) ersetzt sein.

Nachfolgend werden anhand der Figuren 10 bis 13 weitere sehr kompakte Ausführungsbeispiele von erfindungsgemäßen Lötanlagen 1 erläutert. Die Lötanlage gemäß Figur 10 weist zwei Linearförderer 49, 50 zum Hin- und Herbefördern von Baugruppen auf. Die Linearförderer 49, 50 erstrecken sich jeweils über eine kombinierte Löt-/Fluxerstation 51 und eine Vorheizstufe 52.

Die Löt-/Fluxerstationen 51 und die Vorheizstufen 52 sind auf einem gemeinsamen Bewegungstisch 53 angeordnet, der in X- und Y-Richtung mittels entsprechenden Bewegungseinrichtungen (nicht dargestellt) beweglich ausgebildet ist.

Die kombinierte Löt-/Fluxerstation 51 weist jeweils eine Wellenlötvorrichtung mit einem Lötbad und einer Lötdüse 54 und eine Fluxerdüse 55 auf. Die Fluxerdüse 55 ist mit einer Düsenöffnung ausgebildet, die einen Sprühkegel erzeugt, der in etwa dem Durchmesser einer von der jeweiligen Lötdüse 54 erzeugten Lotwelle entspricht.

Die beiden Vorheizstufen 52 weisen jeweils eine Heizdüse 56 auf.

Durch Bewegen des Bewegungstisches 53 führen alle Düsen 54, 55, 56 synchron das gleiche Bewegungsmuster in der X- und Y-Ebene aus.

Die Lötdüsen 54 sind bezüglich der Linearförderer 49, 50 vertikal bewegbar, wobei entweder die Lötdüsen 54 oder die Linearförderer 49, 50 bewegbar ausgebildet sind.

Eine zu lötende Baugruppe wird mittels einer der beiden Linearförderer 49, 50 der kombinierten Löt-/Fluxerstation 51 zugeführt. Zunächst werden die zu lötenden Lötstellen mittels der Fluxerdüse 55 mit Flussmittel besprüht. Ist die Baugruppe vollständig mit Flussmittel besprüht, so wird sie zur benachbarten Vorheizstufe 52 weiterbewegt und auf die gewünschte Bearbeitungstemperatur erhitzt.

Die Baugruppe wird dann zurück zur Löt-/Fluxerstation 51 bewegt. In der kombinierten Löt-/Fluxerstation 51 sind die Lötdüse 54 und die Fluxerdüse 55 in Bewegungsrichtung ein Stück zueinander versetzt. Demenstprechend versetzt wird auch die Baugruppe zum Löten gegenüber der Position zum Besprühen mit Flussmittel in der kombinierten Löt-/Fluxerstation 51 angeordnet.

Auf beiden Linearförderern 49, 50 können gleichzeitig oder auch zeitlich versetzt Baugruppen den jeweiligen Stationen 51, 52 zugeführt werden. Hierbei werden jeweils Baugruppen des gleichen Typs bearbeitet, sodass die Düsen 54-56 synchron mit dem gleichen Bewegungsmuster bewegt werden, wobei die entsprechenden Lötstellen aufeinander folgend bearbeitet werden.

Diese Lötanlage ist sehr kompakt ausgebildet. Dennoch kann auf engstem Raum ein hoher Durchsatz erzielt werden. Zudem ist die Lötanlage 1 einfach ausgebildet, da lediglich eine einzige Bewegungseinrichtung zum Bewegen der Düsen 54-56 aller Stationen 51, 52 vorgesehen ist.

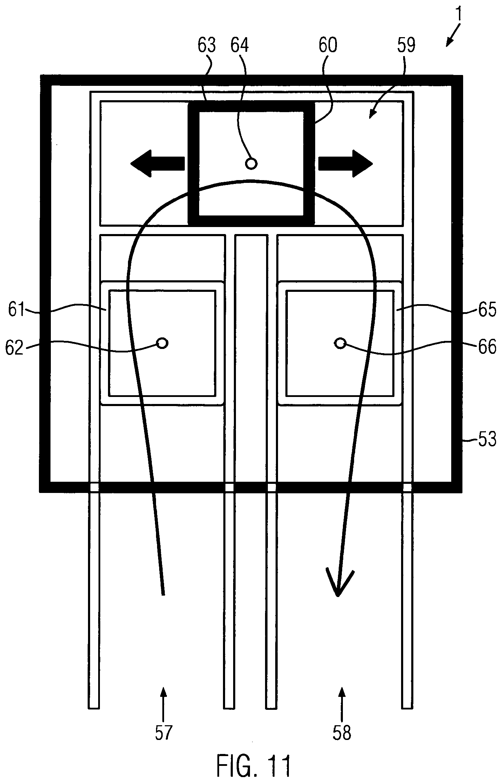

Gemäß einem weiteren Ausführungsbeispiel (Fig. 11) weist eine Lötanlage 1 wiederum einen Bewegungstisch 53 auf, wobei zwei Linearförderer 57, 58 und ein Querförderer 59 vorgesehen sind. Der Querförderer 59 weist einen Schlitten (Shuttle) 60 auf, der angrenzend an den Endbereichen der Linearförderer 57, 58 angeordnet ist und quer zur Förderrichtung der Linearförderer 57, 58 bewegbar ist, sodass der Schlitten 60 in Flucht zu beiden der Linearförderer 57, 58 anordbar ist.

Der Linearförderer 57 bildet einen Einlauf-Förderer, der eine zu lötende Baugruppe in den Bereich über den Bewegungstisch 53 zuführt. Die Baugruppe wird dann vom Schlitten 60 übernommen, mit welchem sie zum Endbereich des anderen Linearförderers 58 bewegt werden kann. Der andere Linearförderer 58 bildet einen Auslauf-Förderer, der vom Querförderer 59 eine Baugruppe übernehmen kann und sie aus dem Bereich des Bewegungstisches 53 wieder herausfördern kann.

Im Bereich des Einlauf-Förderers 57 ist eine Fluxerstation 61 mit einer Fluxer-Düse 62, im Bereich des Querförderers 59 ist eine Vorheizstufe 63 mit einer Vorheizdüse 64 und im Bereich des Auslauf-Förderers 58 ist eine Lötstation 65 mit einer Lötdüse 66 angeordnet. Die Fluxerstation 61, die Vorheizstufe 63 und die Lötstation 65 befinden sich jeweils auf dem Bewegungstisch 53. Sie werden gemeinsam mit dem Bewegungstisch 53 bewegt und führen jeweils das gleiche Bewegungsmuster in der X-/Y-Ebene aus.

Die Vorheizstufe 63 ist im vorliegenden Ausführungsbeispiel in der Längsmitte des Querförderers 59 angeordnet. Sie kann jedoch auch an einer jeden beliebigen anderen Position entlang der Längserstreckung des Querförderers 59 angeordnet sein.

In dieser Lötanlage 1 können der Fluxerstation 61, der Vorheizstufe 63 und der Lötstation 65 sequentiell Baugruppen zugeführt werden, wobei alle drei Stationen 61, 63, 65 jeweils mit einer Baugruppe versehen, die parallel in unterschiedlichen Stationen bearbeitet werden. Es genügt wiederum, eine einzige Bewegungseinrichtung um die Düsen 62, 64 und 66 synchron in allen Stationen zu bewegen.

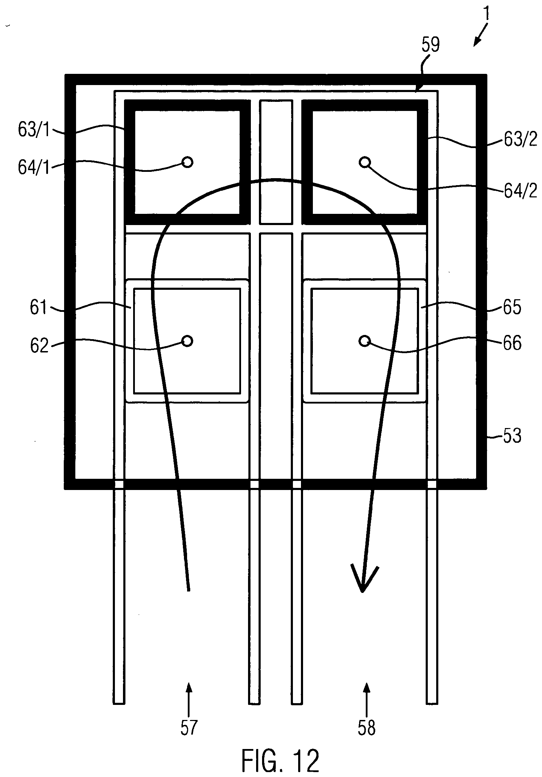

Gemäß einer weiteren Ausführungsform (Figur 12) weist die Lötanlage 1 wiederum einen Bewegungstisch 53, zwei Linearförderer 57, 58 und einen Querförderer 59 auf. Bei diesem Ausführungsbeispiel sind die Linearförderer 57, 58 und der Querförderer 59 jeweils als Bandförderer ausgebildet, wobei sich die beiden Linearförderer 57, 58 bis in den Bereich des Querförderers 59 erstrecken.

Im Bereich des Linearförderers 57 ist eine Fluxerstation 61 mit einer Fluxerdüse 62 angeordnet. Im Bereich des Querförderers 59 sind zwei Vorheizstufen 63/1 und 63/2 angeordnet. Im Bereich des Linearförderers 59 (Auslauf-Förderer) ist eine Lötstation 65 mit einer Lötdüse 66 vorgesehen.

Eine zu lötende Baugruppe wird zunächst mit dem Einlauf-Förderer 57 der Fluxerstation 61, dann der ersten Vorheizstufe 63/1, dann mit dem Querförderer 59 der zweiten Vorheizstufe 63/2 und dann mit dem Auslauf-Förderer 58 der Lötstation 65 aufeinander folgend bzw. sequentiell zugeführt. Alle Stationen können gleichzeitig mit einer Baugruppe versehen sein, sodass diese parallel bearbeitet werden. Die Düsen der einzelnen Stationen werden synchron mittels des Bewegungstisches 53 bewegt.

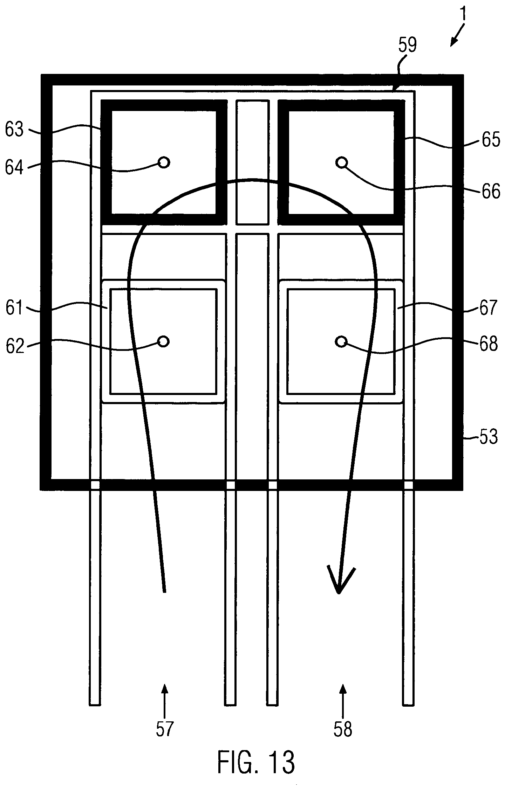

Eine weitere Ausführungsform (Figur 13) weist genauso wie die vorhergehende Ausführungsform einen Einlauf-Förderer 57, einen Querförderer 59 und einen Auslauf-Förderer 58 auf, die sich über den Bereich eines Bewegungstisches 53 erstrecken. Als Prozessstationen sind eine Fluxerstation 61 mit einer Fluxer-Düse 62, eine Vorheizstufe 63 mit einer Vorheizdüse 64, eine Löstation 65 mit einer Lötdüse 66 und eine Prüfeinrichtung (AOI) 67 mit einer Kamera 68 vorgesehen. Diese Stationen befinden sich auf dem gemeinsamen Bewegungstisch 53 und werden von diesem gemeinsam in der X-Y-Ebene bewegt. Hierdurch werden die Fluxer-Düse 62, die Vorheizdüse 64 und die Lötdüse 66 sowie die Kamera 68 synchron zueinander bewegt und fahren jeweils alle Lötstellen einer zu lötenden Baugruppe ab. An allen Stationen können gleichzeitig Baugruppen vorgesehen sein, die parallel bearbeitet werden.

Die schematisch in den Figuren 10 bis 13 dargestellten Ausführungsbeispiele erlauben die gleichzeitige Bearbeitung mehrerer Baugruppen, wobei jeweils lediglich eine einzige Bewegungseinrichtung zum Bewegen der Funktionselemente (Fluxer-Düse, Vorheizdüse, Lötdüse und Kamera) notwendig ist, um diese synchron zu bewegen.

**Bezugszeichenliste**

| | | | |
|---|---|---|---|
| 1 | Lötanlage | 38 | Ausnahmepuffer |
| 2 | Gestell | 39 | Puffer |
| 3 | Einlauf-Förderer | 40 | Vorheizstufe |
| 4 | Auslauf-Förderer | 41 | Kühlstufe |
| 5 | Schaltschrank | 42 | Pfeil |
| 6 | Lotbadtisch | 43 | Beschickungseinrichtung |
| 6a, 6b | Lotbadtische im Zweitischbetrieb (Fign. 2D bis 2F) | 44 | Schiene |
| | | 45 | Bewegungsweg |
| 7 | X-Bewegungsrichtung von 6 | 46 | Reparaturstation |
| 8 | Y-Bewegungsrichtung von 6 | 47 | Steuereinrichtung |
| 9 | Wellenlötvorrichtung | 48 | Transporteinrichtung |
| 10 | Oberheizung mit Pyrometer | 49 | Linearförderer |
| 11 | Z-Bewegungsrichtung von 9 | 50 | Linearförderer |
| 12 | Positionierrahmen | 51 | Löt-/Fluxerstation |
| 13 | Flussmittel-Benetzungseinrichtung (Fluxer) | 52 | Vorheizstufe |
| | | 53 | Bewegungstisch |
| 14 | erste Vorheizstufe | 54 | Lötdüse |
| 15 | zweite Vorheizstufe mit Pyrometer | 55 | Fluxerdüse |
| | | 56 | Heizdüse |
| 16 | erste Kühlstufe | 57 | Linearförderer (Einlauf-Förderer) |
| 17 | zweite Kühlstufe | | |
| 18 | Z-Korrektureinrichtung | 58 | Linearförderer (Auslauf-Förderer) |
| 19 | Anlernvorrichtung | | |
| 20 | Prüfeinrichtung (AOI) | 59 | Querförderer |
| 21 | Einlaufstelle | 60 | Schlitten (Shuttle) |
| 22-30 | Förder- bzw. Handhabungseinrichtungen von Lötgut | 61 | Fluxserstation |
| | | 62 | Fluxerdüse |
| 31 | Auslaufstelle | 63 | Vorheizstufe |
| 32 | Wartungsseite | 64 | Vorheizdüse |
| 33 | Einlauf-Förderrichtung | 65 | Lötstation |
| 34 | Auslauf-Förderrichtung | 66 | Lötdüse |
| 35 | Schlitten (Shuttle) | 67 | Prüfeinrichtung |
| 36 | Doppelpfeil | 68 | Kamera |
| 37 | Bewegungsrichtung | | |

## Patentansprüche

1. Verfahren zum Selektivlöten, mit einer Lötvorrichtung zum Selektivlöten, die
- ein Lötbad zum Vorhalten von geschmolzenem Lot,
- zumindest eine Lötdüse,
- eine Lotpumpe zum Fördern von Lot aus dem Lötbad durch die Lötdüse,
- eine Bewegungseinrichtung zum relativen Bewegen der Lötdüse und einer zu lötenden Baugruppe innerhalb eines Lötbereichs,
- eine Transporteinrichtung zum Zuführen einer zu lötenden Baugruppe zum Lötbereich, wobei die Lötdüse Bestandteil einer Lötdüsenanordnung ist, und die Lötdüsenanordnung eine oder mehrere Lötdüsen aufweist und ihr ein Lötbereich zuordbar ist,
wobei eine in dem Lötbereich befindliche Baugruppe gelötet wird, indem die zumindest eine Lötdüse und die Baugruppe mittels der Bewegungseinrichtung relativ zueinander bewegt werden,
**dadurch gekennzeichnet,**
**dass** zumindest eine weitere Baugruppe bearbeitet wird, indem ein Funktionselement, wie z.B. eine weitere Lötdüse, eine Kamera eine optischen Inspektionssystems, eine Fluxer-Düse oder/und eine Heizdüse, von der Bewegungseinrichtung synchron zu der der anderen Baugruppe zugeordneten Lötdüse in der X-Y-Ebene bewegt wird und wobeiein Lötprogramm zum gleichzeitigen Löten mehrerer Baugruppen ausgeführt wird, und die Baugruppen jeweils durch eine relative Vertikalbewegung zu Lötdüsenanordnungen in das Lötprogramm ein- bzw. ausgekoppelt werden, wobei nicht zu allen Lötdüsenanordnungen gleichzeitig jeweils eine Baugruppe eingekoppelt wird, so
**dass** zumindest zwei Baugruppen zu einem unterschiedlichen Zeitpunkt (asynchron) in das Lötprogramm eingekoppelt worden sind, wobei beim Einkoppeln einer Baugruppe vorzugsweise die relative Bewegung zwischen der Baugruppe und einer der Lötdüsen in der X-Y-Ebene angehalten wird, und/oder dass beim Einkoppeln einer Baugruppe der Fluss des Lotes durch die Lötdüsen angehalten wird.

2. Verfahren zum Selektivlöten nach Anspruch 1, umfassend
**dadurch gekennzeichnet,**
**dass** in einer Lötdüsenanordnung lediglich ein Teilabschnitt eines auszuführenden Lötprogrammes für eine Baugruppe ausgeführt wird, und alle Teilabschnitte, die mit einer Baugruppe an den unterschiedlichen Lötdüsenanordnungen ausgeführt werden, zusammen ein vollständiges Lötprogramm für diese Baugruppe darstellen.

3. Verfahren nach Anspruch 2,
**dadurch gekennzeichnet,**
**dass** die Baugruppen synchron den Lötdüsenanordnungen zugeführt werden, wobei die Baugruppen insbesondere sequentiell zu den Lötdüsenanordnungen befördert werden.

4. Lötvorrichtung zum Selektivlöten, umfassend
- ein Lötbad zum Vorhalten von geschmolzenem Lot,
- zumindest eine Lötdüse,
- eine Lotpumpe zum Fördern von Lot aus dem Lötbad durch die Lötdüse,
- eine Bewegungseinrichtung zum relativen Bewegen der Lötdüse und einer zu lötenden Baugruppe innerhalb eines Lötbereichs,
- einen Positionierrahmen zum Aufnehmen einer Baugruppe,
- eine Beschickungseinrichtung zum Zuführen einer in dem Positionierrahmen angeordneten zu lötenden Baugruppe zum Lötbereich,
**dadurch gekennzeichnet,**
**dass** ein weiteres Funktionselement, wie z.B. eine weitere Lötdüse, eine Kamera eines optischen Inspektionssystems, eine Fluxer-Düse oder/und eine Heizdüse, vorgesehen ist, welcher eine weitere Baugruppe zuordbar ist, wobei ein weiterer Positionierrahmen vorgesehen ist und die weitere Baugruppe in dem weiteren Positionierrahmen angeordnet werden kann, wobei die Bewegungseinrichtung derart ausgebildet ist, dass die Lötdüse und das Funktionselement synchron in der X-Y-Ebene relativ zu jeweils einer der Baugruppen bewegbar sind und wobei mehrere Lötdüsen in mehreren Lötdüsenanordnungen vorgesehen sind, wobei jede Lötdüsenanordnung eine oder mehrere Lötdüsen aufweist, wobei einer jeden Lötdüsenanordnung ein Lötbereich zuordbar ist, und
die Beschickungseinrichtung zum Zuführen von Baugruppen in die mehreren Lötbereiche derart ausgebildet ist, dass die Förderwege der einzelnen Baugruppen derart verzweigen, dass ein jeder Lötbereich unabhängig von den jeweiligen anderen Lötbereichen mit einer Baugruppe beschickt werden kann oder von ihm abgezogen werden kann.

5. Lötvorrichtung zum Selektivlöten nach Anspruch 4,
**dadurch gekennzeichnet,**
**dass** die Transporteinrichtung derart ausgebildet ist, dass zu lötende Baugruppen sequentiell zu Lötdüsenanordnungen befördert werden.

6. Lötvorrichtung zum Selektivlöten nach Anspruch 4 oder 5,
**dadurch gekennzeichnet,**
**dass** die einzelnen Lötdüsenanordnungen und die jeweiligen Baugruppen unabhängig voneinander in Vertikalrichtung (Z-Richtung) mittels einer Koppeleinrichtung zueinander bewegbar sind.

7. Lötvorrichtung nach einem der Ansprüche 4 bis 6,
**dadurch gekennzeichnet,**
**dass** eine oder mehrere X-Y-Bewegungseinheiten definiert sind, wobei jede X-Y-Bewegungseinheit eine oder mehrere, vorzugsweise jeweils eine gleiche Anzahl von Lötdüsenanordnungen und/oder Funktionselementen aufnimmt, wobei die Bewegungseinrichtung derart ausgebildet ist, dass mehrere Gruppen mit zumindest jeweils zwei X-Y-Bewegungseinheiten unabhängig voneinander in der X-Y-Ebene bewegbar sind.

8. Lötvorrichtung nach einem der Ansprüche 4 bis 7
**dadurch gekennzeichnet,**
**dass** jeder Lötdüsenanordnung ein Lötbad mit wenigstens einer Lotpumpe zugeordnet ist und/oder
**dass** Lötdüsen unterschiedlicher Art vorgesehen sind, wobei die Arten von Lötdüsen sich in Form und/oder Durchmesser einer Lotaustrittsöffnung und/oder in einer Belotung oder Nichtbelotung einer Düsenwandung unterscheiden, wobei vorzugsweise Lötdüsen einer einzigen Art in einer Lötdüsenanordnung zusammengefasst sind.

9. Lötvorrichtung nach einem der Ansprüche 4 bis 8,
**dadurch gekennzeichnet,**
**dass** die Koppeleinrichtung derart ausgebildet ist, dass jede Lötdüsenanordnung insgesamt oder einzelne oder Gruppen der Lötdüsen jeder Lötdüsenanordnung unabhängig von anderen Lötdüsen der selben Lötdüsenanordnung in Vertikalrichtung bewegbar ist bzw. sind.

10. Lötvorrichtung nach einem der Ansprüche 4 bis 9,
**dadurch gekennzeichnet,**
**dass** die Bewegungseinrichtung derart ausgebildet ist, dass einzelne oder alle Lötdüsen um eine Lötdüsen-Längsachse drehbar sind und/oder
**dass** die Bewegungseinrichtung derart ausgebildet ist, dass mehrere Baugruppen gemeinsam synchron in der X-Y-Ebene bewegbar sind und/oder dass die Bewegungseinrichtung derart ausgebildet ist, dass die Baugruppen um eine vertikale Achse drehbar sind.

11. Lötvorrichtung nach einem der Ansprüche 4 bis 10,
**dadurch gekennzeichnet,**
**dass** mehrere Baugruppenhalteeinrichtungen zum Aufnehmen jeweils einer Baugruppe vorgesehen sind, und
**dass** die Beschickungseinrichtung zum Einsetzen der Baugruppen in die jeweiligen Baugruppenaufnahmeeinrichtungen und zum Entnehmen der Baugruppen aus den jeweiligen Baugruppenaufnahmeeinrichtungen ausgebildet ist, wobei die Beschickungseinrichtung vorzugsweise einen einzigen Greifer zum Einsetzen und Entnehmen von Baugruppen bzw. Werkstückträgern aufweist.

12. Lötvorrichtung nach einem der Ansprüche 4 bis 11,
**dadurch gekennzeichnet,**
**dass** die Koppeleinrichtung derart ausgebildet ist, dass die einzelnen Baugruppen unabhängig voneinander in Z-Richtung bewegbar sind und/oder
**dass** die Bewegungseinrichtung derart ausgebildet ist, dass einzelne oder alle Lötdüsen um eine Lötdüsen-Längsachse drehbar sind und/oder dass die Bewegungseinrichtung derart ausgebildet ist, dass mehrere Baugruppen gemeinsam synchron in der X-Y-Ebene bewegbar sind und/oder
**dass** die Bewegungseinrichtung derart ausgebildet ist, dass die Baugruppen um eine vertikale Achse drehbar sind und/oder dass eine Halteeinrichtung, wie z.B. ein Positionierrahmen, vorgesehen ist, mit welchen die Baugruppen gegenüber der X-Y-Ebene kippbar sind, wobei ein Kippwinkel zwischen 5° und 15°, vorzugsweise zwischen 7° und 12° festlegbar ist.

13. Lötvorrichtung nach einem der Ansprüche 4 bis 12,
**dadurch gekennzeichnet,**
**dass** die Funktionseinheit eine Fluxer-Düse ist, wobei die Fluxer-Düse mit einer einstellbaren Düsenöffnung ausgebildet ist, so dass ein Sprühkegel der Fluxer-Düse einstellbar ist.

## Claims

1. Method of selective soldering, with a soldering apparatus for selective soldering, having
- a solder bath for holding molten solder
- at least one solder nozzle,
- a solder pump for conveying solder from the solder bath through the solder nozzle
- a movement device for the relative movement of the solder nozzle and an assembly to be soldered within a soldering zone,
- a conveying device for feeding an assembly to be soldered to the soldering zone, wherein the solder nozzle is part of a solder nozzle assembly, and the solder nozzle assembly has one or more solder nozzles and may be assigned a soldering zone
- wherein an assembly positioned in the soldering zone is soldered, while at least one solder nozzle and the assembly are moved relative towards one another by means of the movement device,
**characterised in that**
at least one further assembly is processed, while a function element such as e.g. a further solder nozzle, a camera of an optical inspection system, a fluxer nozzle and/or a heating nozzle are moved in the X-Y plane synchronously to the solder nozzle assigned to the other assembly and wherein a soldering program for soldering synchronously a plurality of assemblies is carried out, and the assemblies are in each case are coupled into and out of the soldering program through a vertical movement relative to the solder nozzle assemblies, wherein in each case an assembly is not coupled into all solder nozzle assemblies simultaneously, so that at least two assemblies have been coupled into the soldering program at a different point in time (asynchronously), wherein during coupling of an assembly into a solder nozzle assembly, the relative movement between the assembly and one of the solder nozzles in the X-Y plane is preferably stopped, and/or that during coupling of an assembly, the flow of solder through the solder nozzles is stopped.

2. Method of selective soldering according to claim 1
**characterised in that**
in one solder nozzle assembly only a portion of a soldering program to be executed is executed for one assembly, and all portions executed on one assembly at the different solder nozzle assemblies together represent a complete soldering program for this assembly.

3. Method according to claim 2
**characterised in that**
the assemblies are fed synchronously to the solder nozzle assemblies, with the assemblies being conveyed in particular sequentially to the solder nozzle assemblies.

4. Soldering apparatus for selective soldering, comprising
- a solder bath for holding the molten solder,
- at least one solder nozzle,
- a solder pump for conveying solder from the solder bath through the solder nozzle,
- a movement device for the relative movement of the solder nozzle and an assembly to be soldered within a soldering zone,
- a feeding device for feeding an assembly to be soldered to the soldering zone, **characterised in that**
a further function element such as e.g. a further solder nozzle, a camera of an optical inspection system, a fluxer nozzle and/or a heating nozzle is provided, which may be assigned to another assembly, and the movement device is so designed that the solder nozzle and the function element may be moved synchronously in the X-Y plane relative to one of the other assemblies in each case, and wherein several solder nozzles are provided in several solder nozzle assemblies, with each solder nozzle assembly having one or more solder nozzles and wherein each solder nozzle assembly is assigned a soldering zone, and the feeding device is so designed for the feeding of assemblies into the various soldering zones that the conveyance paths of the individual assemblies branch out in such a way that each soldering zone may be fed with an assembly or have an assembly removed from it independently of the other respective soldering zones.

5. Soldering apparatus for selective soldering according to claim 4,
**characterised in that**
the conveying device is so designed that assemblies to be soldered are conveyed to solder nozzle assemblies in sequence.

6. Soldering apparatus for selective soldering according to claim 4 or 5,
**characterised in that**
the individual solder nozzle assemblies and the respective assemblies may be moved independently of one another in the vertical direction (Z-direction) by means of a coupling device.

7. Soldering apparatus for selective soldering according to any of claims 4 to 6
**characterised in that**
one or more X-Y direction movement units are defined, wherein each X-Y movement unit accommodates one or more, preferably in each case an equal number of solder nozzle assemblies, wherein the movement device is so designed that several groups of X-Y movement units may be moved in the X-Y plane independently of one another.

8. Soldering apparatus for selective soldering according to any of claims 4 to 7
**characterised in that**
each solder nozzle assembly is assigned a solder bath with at least one solder pump and/or
that solder nozzles of various forms may be provided, wherein the types of solder nozzle may differ in the shape and/or diameter of a solder outlet orifice and/or in soldering or non-soldering of a nozzle wall, wherein preferably solder nozzles of a single type are combined in one solder nozzle assembly.

9. Soldering apparatus for selective soldering according to any of claims 4 to 8,
**characterised in that**
the coupling device is so designed that each solder nozzle assembly as a whole or individually or groups of solder nozzles of each solder nozzle assembly is or are movable in the vertical direction independently of other solder nozzles of the same solder nozzle assembly.

10. Soldering apparatus for selective soldering according to any of claims 4 to 9,
**characterised in that**
the movement device is so designed that individual or all solder nozzles are rotatable around a solder nozzle longitudinal axis and/or that the movement device is so designed that several assemblies may be moved together synchronously in the X-Y plane and /or that the movement device is so designed that the assemblies are rotatable around a vertical axis.

11. Soldering apparatus for selective soldering according to any of claims 4 to 10
**characterised in that**
several assembly holding fixtures are provided, each for holding one assembly, and
that the feeding device is designed for inserting the assemblies into and removing them from the respective assembly holding fixtures, wherein the feeding device preferably has a single gripper for insertion and removal of assemblies or work holding fixtures.

12. Soldering apparatus for selective soldering according to any of claims 4 to 11,
**characterised in that**
the coupling device is so designed that the individual assemblies may be moved in the Z-direction independently of one another and/or
that the movement device is so designed that several assemblies may be moved together synchronously in the X-Y plane and /or
that the movement device is so designed that the assemblies are rotatable around a vertical axis and/or that a holding fixture, such as e.g. a positioning frame, is provided and may be used to tilt the assemblies relative to the X-Y plane, wherein a tilt angle of between 5 and 15°, preferably between 7 and 12° may be set.

13. Soldering apparatus for selective soldering according to any of claims 4 to 12
**characterised in that**
the function unit is a fluxer nozzle, wherein the fluxer nozzle is designed with an adjustable nozzle orifice, so that a spray cone of the fluxer nozzle is adjustable.

## Revendications

1. Procédé de brasage sélectif avec un appareil de brasage pour le brasage sélectif, qui
- un bain de soudure pour maintenir de la soudure en fusion,
- au moins une buse à soudure,
- une pompe de soudure pour pomper de la soudure du bain de soudure par la buse à soudure,
- un moyen de déplacement pour le déplacement relatif de la buse à soudure et d'un assemblage à braser dans une zone de brasage,
- un moyen de transport pour amener un assemblage à braser vers la zone de brasage, dans lequel la buse à soudure fait partie d'une disposition de buses à soudure, et la disposition de buses à soudure comporte une ou plusieurs buses à soudure et une zone de brasage lui étant assignable,
dans lequel un assemblage se trouvant dans la zone de brasage est brasé par ce qu'au moins une buse à soudure et l'assemblage sont déplacé relativement l'un par rapport à l'autre par le moyen de déplacement,
**caractérisé par** ce
qu'au moins un autre assemblage est travaillé par ce qu'un élément fonctionnel, tel qu'une autre buse à soudure, une caméra d'un système d'inspection optique, une buse de fluxer et / ou une buse de chauffage, est déplacé par le moyen de déplacement en synchronisme par rapport à la buse à soudure assignée à l'autre assemblage dans le plan X-Y et dans lequel un programme de soudure pour le brasage synchrone de plusieurs assemblages est effectué, et les assemblages sont respectivement couplés ou découplés par rapport au programme de soudure par un mouvement vertical relatif par rapport à des dispositions de buses à soudure, dans lequel respectivement un assemblage n'est pas couplé à toutes les dispositions de buses à soudure en même temps, de telle manière qu'au moins deux assemblages ont été couplé à un moment différent (asynchronément) dans le programme de soudure, dans lequel, durant le couplage d'un assemblage, préférablement le mouvement relatif entre l'assemblage et une des buses à soudure est arrêté dans le plan X-Y, et / ou que durant le couplage d'un assemblage le flux de la soudure par les buses à soudure est arrêté.

2. Procédé de brasage sélectif selon la revendication 1, comportant
**caractérisé par** ce
que dans une disposition de buses à soudure seulement une partie d'un programme de soudure à être effectué pour un assemblage est effectué, et que toutes les parties qui sont effectués avec un assemblage aux différentes dispositions des buses à soudure ensemble représentent un programme de soudure complet.

3. Procédé selon la revendication 2,
**caractérisé par** ce
que les assemblages sont amené vers les dispositions des buses à soudure en synchronisme, dans lequel les assemblages sont transporté séquentiellement vers les dispositions des buses à soudure.

4. Appareil de brasage pour le brasage sélectif, comportant
- un bain de soudure pour maintenir de la soudure en fusion,
- au moins une buse à soudure,
- une pompe de soudure pour pomper de la soudure du bain de soudure par la buse à soudure,
- un moyen de déplacement pour le déplacement relatif de la buse à soudure et d'un assemblage à braser dans une zone de brasage,
- un cadre de positionnement pour l'accueil d'un assemblage,
- un dispositif d'alimentation pour la conduction d'un assemblage à braser disposée dans le cadre de positionnement vers la zone de brasage,
**caractérisé par** ce
qu'un autre élément fonctionnel, tel qu'une autre buse à soudure, une caméra d'un système d'inspection optique, une buse de fluxer et / ou une buse de chauffage, est prévu, auquel un autre assemblage est assignable, dans lequel un autre cadre de positionnement est prévu et l'autre assemblage peut être disposé dans l'autre cadre de positionnement, dans lequel le moyen de déplacement est effectué tel que la buse à soudure et l'élément fonctionnel sont muables en synchronisme dans le plan X-Y relativement par rapport à respectivement un des assemblages et dans lequel plusieurs buses à soudure sont prévues dans plusieurs dispositions de buses à soudure, dans lequel chaque disposition de buses à soudure comporte une ou plusieurs buses à soudure, dans lequel une zone de soudure est assignable à chacune des dispositions de buses à soudure, et
que le dispositif d'alimentation pour la conduction d'assemblages dans les plusieurs zones de soudure est effectué tel, que les chemins de transport des assemblages respectifs se ramifient tel, que chaque zone de soudure peut être alimenté avec un assemblage indépendamment des autres zones de soudure respectives ou lui peut être prélevé.

5. Appareil de brasage pour le brasage sélectif selon la revendication 4,
**caractérisé par** ce
que le moyen de transport est effectué tel, que des assemblages à braser sont transportés séquentiellement vers des dispositions de buses à soudure.

6. Appareil de brasage pour le brasage sélectif selon la revendication 4 ou 5,
**caractérisé par** ce
que les dispositions de buses à soudure respectives et les assemblages respectifs sont muables indépendamment l'un de l'autre l'un vers l'autre dans la direction verticale (direction Z) par le moyen d'un dispositif de couplage.

7. Appareil de brasage selon l'une des revendications 4 à 6,
**caractérisé par** ce
qu'une ou plusieurs unités de déplacement X-Y sont définis, dans lequel chaque unité de déplacement X-Y accueille un ou plusieurs, de préférence respectivement un nombre égal de dispositions de buses à soudure et/ou d'éléments fonctionnels, dans lequel la direction de déplacement est effectué tel, que plusieurs groupes avec au moins deux unités de déplacement X-Y sont muables indépendamment les uns par rapport aux autres dans le plan X-Y.

8. Appareil de brasage selon l'une des revendications 4 à 7,
**caractérisé par** ce
qu'a chaque disposition de buses à soudure un bain de soudure avec au moins une pompe de soudure est assignable, et/ou
que des buses à soudure de type différents sont prévues, dans lequel les types de buses à soudure différent les uns des autres par la forme et/ou le diamètre d'une ouverture de sortie de soudure et/ou un brasage ou non-brasage d'une paroi de buse, dans lequel préférablement des buses à soudure d'un seul type sont regroupés dans une disposition de buses à soudure.

9. Appareil de brasage selon l'une des revendications 4 à 8,
**caractérisé par** ce
que le dispositif de couplage est effectué tel, que chaque disposition de buses à soudure en total ou des buses à soudure individuelles ou des groupes de buses à soudure de chaque disposition de buses à soudure est ou sont verticalement muables indépendamment d'autres buses à soudure de la même disposition de buses à soudure.

10. Appareil de brasage selon l'une des revendications 4 à 9,
**caractérisé par** ce
que le moyen de déplacement est effectué tel, que des buses à soudure individuelles ou toutes les buses à soudures peuvent être tournés autour d'un axe de buses à soudure et/ou que le moyen de déplacement est effectué tel, que plusieurs assemblages sont muables ensemble en synchronisme dans le plan X-Y et/ou que le moyen de déplacement est effectué tel, que les assemblages peuvent être tournés autour d'un axe vertical.

11. Appareil de brasage selon l'une des revendications 4 à 10,
**caractérisé par** ce
que plusieurs dispositifs de prise d'assemblage pour l'accueil de respectivement un assemblage sont prévus, et
que le dispositif d'alimentation est formé pour la mise des assemblages dans les dispositifs de prise d'assemblage et pour le prélèvement des assemblages des dispositifs de prise d'assemblage respectifs, dans lequel le dispositif d'alimentation préférablement comporte une seule griffe pour la mise et le prélèvement d'assemblages ou de support de pièces à souder.

12. Appareil de brasage selon l'une des revendications 4 à 11,
**caractérisé par** ce
que le dispositif de couplage est effectué tel, que les assemblages individuels sont muable indépendamment les uns des autres dans la direction Z et / ou que le moyen de déplacement est effectué tel, que des buses à soudure individuelles ou toute les buses à soudure peuvent être tourné autour d'un axe longitudinal de buses à souder et / ou que la direction de mouvement est effectuée tel, que les assemblages peuvent être tourné autour d'un axe vertical et / ou qu'un dispositif de prise, tel qu'un cadre de positionnement, est prévu, avec lequel les assemblages sont basculable, dans lequel und angle de basculement est définissable entre 5° et 15°, préférablement entre 7° et 12°.

13. Appareil de brasage selon l'une des revendications 4 à 12,
**caractérisé par** ce
que l'unité fonctionelle est une buse de fluxer, dans lequel la buse de fluxer est effectuée avec une ouverture de buse ajustable, tel qu'un cône de jaillissement de la buse de fluxer est ajustable.
